# EUROPEAN PATENT APPLICATION

(11) **EP 4 760 332 A1**
(43) Date of publication of application: **17.06.2026**
(21) Application number: 24218798.7
(22) Date of filing: 10.12.2024
(51) Int. Cl.: G01R 33/567

(54) **SYNCHRONIZING MRI DATA ACQUISITIONS WITH A CARDIAC CYCLE**

(71) Applicant: Koninklijke Philips N.V., 5656 AE Eindhoven (NL)
(72) Inventor: WEIß, Steffen, Eindhoven (NL)
(74) Representative: Philips Intellectual Property & Standards

(57) **Abstract**

Disclosed herein is a method for synchronizing MRI data acquisitions of a heart of a subject (118) with a cardiac cycle of the heart using photoplethysmography data (320; 410). The method comprises receiving the photoplethysmography data (320; 410), detecting a first cardiac trigger (322; 412), which is indicative of a start of a first ventricular systole (420) of a first cardiac cycle, using the received photoplethysmography data (320; 410), and, in response to the detecting of the first cardiac trigger (322; 412), performing a time-delayed first triggering of a first magnetic resonance imaging data acquisition before a start of a ventricular contraction of a second ventricular systole (434) of a second cardiac cycle following the first cardiac cycle.

## Description

### FIELD OF THE INVENTION

The invention relates to the field of magnetic resonance imaging, in particular it relates to a synchronizing of magnetic resonance imaging data acquisitions of a heart of a subject with a cardiac cycle of the heart using photoplethysmography data of the subject.

### BACKGROUND OF THE INVENTION

Photoplethysmography (PPG) is a technique that uses changes in light interaction, e.g., light absorption, to measure blood volume changes in the microvasculature. For example, an optical sensor may be used to detect light that is scattered by living tissue, such as the skin, mucous membranes, and other translucent tissues of a subject. The detected light may be used to determine a PPG signal descriptive of the blood volume changes in the microvasculature. However, when trying to use a PPG signal for triggering a magnetic resonance imaging data acquisition problems may arise.

### SUMMARY OF THE INVENTION

The invention provides for a method for synchronizing magnetic resonance imaging data acquisitions of a heart of a subject with a cardiac cycle of the heart using photoplethysmography data of the subject in the independent claims. The invention further provides for computer program as well as for a medical system comprising a computational system for synchronizing magnetic resonance imaging data acquisitions of a heart of a subject with a cardiac cycle of the heart using photoplethysmography data of the subject in the independent claims. Exemplary embodiments are given in the dependent claims.

In one aspect, a method for synchronizing magnetic resonance imaging data acquisitions of a heart of a subject with a cardiac cycle of the heart using photoplethysmography data of the subject is disclosed. The method comprises receiving the photoplethysmography data. The method comprises detecting a first cardiac trigger using the received photoplethysmography data. The first cardiac trigger is indicative of a start of a first ventricular systole of a first cardiac cycle. The method comprises, in response to the detecting of the first cardiac trigger, performing a time-delayed first triggering of a first magnetic resonance imaging data acquisition before a start of a ventricular contraction of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

The method comprises updating the time delay using the acquired first magnetic resonance imaging data to provide an updated time delay. The updated time delay is used for performing a time-delayed further triggering of a further magnetic resonance imaging data acquisition in response to detecting a further cardiac trigger using the received photoplethysmography data. The further triggering is time-delayed relative to the detecting of the further cardiac trigger using the updated time delay.

In another aspect, a computer program for synchronizing magnetic resonance imaging data acquisitions of a heart of a subject with a cardiac cycle of the heart using photoplethysmography data of the subject is disclosed. The computer program comprises machine executable instructions for execution by a computational system. Execution of the machine executable instructions causes the computational system to perform a method for synchronizing magnetic resonance imaging data acquisitions of a heart of a subject with a cardiac cycle of the heart using photoplethysmography data of the subject. The method comprises receiving the photoplethysmography data. The method comprises detecting a first cardiac trigger using the received photoplethysmography data. The first cardiac trigger is indicative of a start of a first ventricular systole of a first cardiac cycle. The method comprises, in response to the detecting of the first cardiac trigger, performing a time-delayed first triggering of a first magnetic resonance imaging data acquisition before a start of a ventricular contraction of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

The method comprises updating the time delay using the acquired first magnetic resonance imaging data to provide an updated time delay. The updated time delay is used for performing a time-delayed further triggering of a further magnetic resonance imaging data acquisition in response to detecting a further cardiac trigger using the received photoplethysmography data. The further triggering is time-delayed relative to the detecting of the further cardiac trigger using the updated time delay.

In another aspect, a medical system comprising a computational system for synchronizing magnetic resonance imaging data acquisitions of a heart of a subject with a cardiac cycle of the heart using photoplethysmography data of the subject is disclosed. The computational system comprises a memory storing machine executable instructions. Execution of the machine executable instructions causes the computational system to perform a method for synchronizing magnetic resonance imaging data acquisitions of a heart of a subject with a cardiac cycle of the heart using photoplethysmography data of the subject. The method comprises receiving the photoplethysmography data. The method comprises detecting a first cardiac trigger using the received photoplethysmography data. The first cardiac trigger is indicative of a start of a first ventricular systole of a first cardiac cycle. The method comprises, in response to the detecting of the first cardiac trigger, performing a time-delayed first triggering of a first magnetic resonance imaging data acquisition before a start of a ventricular contraction of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

The method comprises updating the time delay using the acquired first magnetic resonance imaging data to provide an updated time delay. The updated time delay is used for performing a time-delayed further triggering of a further magnetic resonance imaging data acquisition in response to detecting a further cardiac trigger using the received photoplethysmography data. The further triggering is time-delayed relative to the detecting of the further cardiac trigger using the updated time delay.

### BRIEF DESCRIPTION OF THE DRAWINGS

In the following preferred embodiments of the invention will be described, by way of example only, and with reference to the drawings in which:
Fig. 1 shows an exemplary method for synchronizing MRI data acquisitions of a heart of a subject with a cardiac cycle of the heart using PPG data of the subject;
Fig. 2 shows an exemplary method for synchronizing MRI data acquisitions of a heart of a subject with a cardiac cycle of the heart using PPG data of the subject;
Fig. 3 shows an exemplary method for synchronizing MRI data acquisitions of a heart of a subject with a cardiac cycle of the heart using PPG data of the subject;
Fig. 4 shows an exemplary method for updating a time delay;
Fig. 5 shows an exemplary method for updating a time delay;
Fig. 6 shows an exemplary method for using magnetic resonance imaging data acquired by a time-delayed triggering;
Fig. 7 shows an exemplary method for using magnetic resonance imaging data acquired by a time-delayed triggering;
Fig. 8 illustrates an exemplary trigger delay occurring, when using a PPG based triggering for a magnetic resonance imaging data acquisition;
Fig. 9 shows a time-delayed performing of a triggering of a magnetic resonance imaging using a time delay;
Fig. 10 shows exemplary magnetic resonance images, which may be reconstructed using magnetic resonance imaging data acquired with a SENC pulse sequence;
Fig. 11 shows an exemplary pulse sequence 420 in form of an exemplary SENC pulse sequence;
Fig. 12 shows an exemplary computational system of an exemplary medical device; and
Fig. 13 shows an exemplary medical system comprising an MRI system, optical sensor, and computational system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

In an example, a method for synchronizing magnetic resonance imaging data acquisitions of a heart of a subject with a cardiac cycle of the heart using photoplethysmography data of the subject comprises receiving the photoplethysmography data. A first cardiac trigger is detected using the received photoplethysmography data. The first cardiac trigger is indicative of a start of a first ventricular systole of a first cardiac cycle. In response to the detecting of the first cardiac trigger, a time-delayed first triggering of a first magnetic resonance imaging data acquisition is performed before a start of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

The method further comprises updating the time delay using the acquired first magnetic resonance imaging data to provide an updated time delay. The updated time delay is used for performing a time-delayed further triggering of a further magnetic resonance imaging data acquisition in response to detecting a further cardiac trigger using the received photoplethysmography data. The further triggering is time-delayed relative to the detecting of the further cardiac trigger using the updated time delay.

PPG refers to a detection of pulsating blood propagating in the cardiovascular system which changes the blood volume in the microvascular tissue bed under the skin with each heartbeat, generating periodic changes of intensity and color of light scattered at the skin. For acquiring the received photoplethysmography data, e.g., an optical sensor in contact with the subject's skin may be used. Alternatively, the received photoplethysmography data may, e.g., be acquired using remote photoplethysmography. Remote photoplethysmography (rPPG) refers to a remote, i.e., non-contact detection of pulsating blood propagating in the cardiovascular system.

An optical sensor may be used to acquire optical sensor data comprising light scattered at a target area of the subject's skin. The optical sensor data acquired over time may be used for providing a stream, e.g., a video stream, of light scattered at the target area and extract subtle color changes in the skin to generate PPG data, i.e., a PPG signal, caused by changes in light absorption. The light being scattered may, e.g., be ambient light illuminating the target area and/or light emitted by one or more light sources used to illuminate the target area. For example, the target area is a target area within a head and/or neck region of a subject.

Using rPPG, no physical sensor is required to be in contact with the skin. This may have the beneficial effect that using rPPG a PPG signal of a subject arranged within a magnetic resonance imaging system may be acquired without a physical sensor being arranged in contact with the subject, e.g., within a bore of the magnetic resonance imaging subject. Thereby, problems in view of space restrictions within the magnetic resonance imaging system and/or strong magnetic and radio frequency fields generated within the bore of the magnetic resonance imaging system may be avoided for the sensor.

With each cardiac cycle blood is pumped to the periphery by the heart resulting in a pulsed blood flow through the skin tissue. A plethysmogram optically obtained, e.g., using rPPG, may be used to detect blood volume changes in the microvascular bed of skin tissue resulting from this pulsed blood flow.

Since the skin is richly perfused, it is in general relatively easy to detect the pulsatile component of the cardiac cycle. A DC component of the signal may be attributable to the bulk absorption of the skin tissue, while an AC component may be attributable to variation in blood volume in the skin caused by the pressure pulse of the cardiac cycle. A height of the AC component of the photoplethysmogram may be proportional to the pulse pressure, i.e., the difference between the systolic and diastolic pressure in the arteries.

Information about physiological processes, like a cardiac cycle determined using the PPG data, may be used for triggering an MRI data acquisition depending on the respective physiological process. A cardiac trigger detected using the received photoplethysmography data may, e.g., be indicative of starts of ventricular systoles during cardiac cycles monitored using the photoplethysmography data. Cardiac triggers may, e.g., be descriptive of main ventricular depolarizations indicating the starts of the ventricular systoles. Such cardiac trigger may, e.g., be points of a PPG signal provided by received photoplethysmography data, at which a tangent to a local minimum of the PPG signal intersects with a tangent to a local maximum of a first derivative of the PPG signal.

Examples may use a PPG-based cardiac triggering of magnetic resonance imaging data acquisitions for acquiring magnetic resonance data of a heart. For different types of magnetic resonance imaging, like, e.g., for cardiac magnetic resonance imaging, for quantitative flow magnetic resonance imaging, and/or for neuro applications of magnetic resonance imaging, a magnetic resonance imaging data acquisition in synchronization with the cardiac cycle may be required. Examples may enable a replacing of an ECG triggering of a magnetic resonance imaging data acquisition by a PPG triggering, in particular by a PPG triggering using rPPG. Thus, an ECG signal detection requiring patch electrodes may be avoided. For example, an ECG triggering using a detected R-peak in the ECG signal as a cardiac trigger may be replaced by the PPG triggering.

The photoplethysmography data may, e.g., be acquired using remote photoplethysmography. For the remote acquisition of the photoplethysmography data, an optical sensor, e.g., a camera may be used. The optical sensor may be used to monitor a photoplethysmography observation site, i.e., target area, of the subject, e.g., a face of the subject. Using photoplethysmography, in particular remote photoplethysmography, for detecting cardiac triggers may, e.g., have one or more of the following advantages: a short patient preparation workflow, in particular a shorter patient preparation workflow compared to an ECG-triggering; a reduction of an operator dependence, in particular an avoiding of an operator dependence caused by an incorrect placement of ECG-patches; an avoiding of inconvenience for the subject, like shaving and/or exposure of skin in the upper body area; a reducing of a risks of a cross-contamination; a reducing of waste, e.g., from disposable patches; a potentially more robust triggering, e.g., for an obese subject; a potentially more robust triggering for a main magnetic field larger than 3T.

Examples may enable and/or improve a usage of a PPG triggering for acquiring magnetic resonance imaging data of a heart. Examples may have the beneficial effect of enabling a synchronization of the magnetic resonance imaging data acquisition with the cardiac cycle of the heart. Examples may in particular enable a handling of delays introduced, when detecting PPG-based cardiac triggers, compared to the cardiac states during the cardiac cycles, which cause the respective cardiac triggers. For example, a cardiac trigger may be descriptive of a main ventricular depolarization indicating a start of a ventricular systole. However, the respective cardiac trigger caused by the main ventricular depolarization and comprised by the photoplethysmography data may only be detected in the receiving the photoplethysmography data with a delay relative to the occurrence of the main ventricular depolarization. For example, compared to electrocardiogram (ECG) based triggering, PPG triggering introduces some extra delay relative to ECG-triggering. This extra delay may be caused by two effects. Firstly, after an R-peak of an ECG, which identifies a main ventricular depolarization of a ventricular systole, a blood flush needs to be generated, which corresponds to a period of time referred to as the pre-ejection period (PEP), and it needs to travel from the heart to an PPG observation site, e.g., a subject's face. This travel time is referred to as pulse transit time (PTT). The combination of PEP and PTT is the pulse arrival time (PAT). Secondly, a PPG signal is of a more low-frequent nature than, e.g., an R-peak of the ECG which results in some extra algorithmic delay required to robustly identify a cardiac trigger in the PPG, i.e., a PPG marker, e.g., for the onset of the blood flush in the face. While this algorithmic delay may be approximately constant and known from the type of image or video processing used for processing the PPG signal as well as from the type of trigger identification, the PAT may in general be patient specific. An overall PPG trigger delay, i.e., a delay between a cardiac process step during a cardiac cycle and a cardiac trigger detectible in the PPG signal, which is descriptive of this cardiac process step, may, e.g., be in the order of 200 ms to 300 ms. This PPG trigger delay makes it challenging to use a PPG signal for triggering a magnetic resonance data acquisition synchronous to specific states of the cardiac cycle.

Considering, e.g., a magnetic resonance data acquisition using a SENC pulse sequence. A triggering a magnetic response data acquisition at the time, when a main ventricular depolarization of a cardiac cycle, which corresponds to the R-peak in the ECG, is detected in the PPG signal, would result in a strain encoding, which is done during the end of the ventricular systole, and mainly only the strain in the diastole would be measured, which is clinically not relevant. Even if strain of a part of the next ventricular systole is measured, problems with the signal-to-noise ratio of this strain data would arise, since the encoding is subject to T1 relaxation.

Examples may enable a usage of SENC pulse sequences for magnetic resonance data acquisition with an PPG signal based triggering of the acquisition.

Examples may enable a usage of a PPG triggering for a magnetic resonance data acquisition, even though a detection of a cardiac trigger using the PPG signal may be too late for a magnetic resonance data acquisition of a ventricular systole of current cardiac cycle, which comprises the respective cardiac trigger. Examples suggest to time-delay the triggering magnetic resonance imaging data acquisition to acquire magnetic resonance imaging data during a next ventricular systole. This time delay used for the time delayed triggering may, e.g., be continuously updated. Such a continuous adjusting may further improve the synchronization of the time-delayed magnetic resonance imaging data acquisitions with the cardiac cycle. For example, image processing of magnetic resonance images reconstructed using the magnetic resonance data being acquired may be used to continuously adjust the time delay. Furthermore, image processing of magnetic resonance images reconstructed using the magnetic resonance data being acquired may be used to annotate the images with times codes regarding an estimated time of main ventricular depolarization corresponding to an R-peak time in ECG. Finally, the magnetic resonance images reconstructed using the acquired magnetic resonance imaging data may, e.g., be fed into an evaluation and representation of regional cardiac strain of the heart of the subject.

For example, the time delay may be configured to trigger the first magnetic resonance imaging data acquisition 100 ms before the start of the second ventricular systole. For example, the time delay may be configured to trigger the first magnetic resonance imaging data acquisition two cardiac phases before the start of the second ventricular systole. In case of cardiac phases of a length of 50 ms, this corresponds to a triggering 100 ms before start of the second ventricular systole.

For example, the time delay used for the time-delayed first triggering of the first magnetic resonance imaging data acquisition may, e.g., be an estimated initial time delay. Such an initial time delay may, e.g., be estimated using an estimated cardiac cycle length and an estimated trigger delay. The estimated cardiac cycle length may, e.g., be estimated using an extrapolating of time intervals measured between cardiac triggers detected in the photoplethysmography data in advance of the detecting of the first cardiac trigger. A cardiac cycle length may, e.g., correspond to a time interval t_{RR} between two consecutive cardiac triggers. The cardiac cycle length may, e.g., be extrapolated based on time intervals between the last m PPG triggers detected using the photoplethysmography data. For example, m may be selected to be m = 5. An estimated initial PPG trigger delay d_{PPG} may, e.g., be estimated to lie at an upper end of a distribution of a plurality of known, e.g., measured, PPG trigger delays. The plurality of known PPG trigger delays may, e.g., be measured for a representative group of subjects. The estimated trigger delay d_{PPG} may, e.g., be estimated using a trigger delay from an upper end of a histogram of trigger delays measured for the representative group of subjects. For example, the initial PPG trigger delay may, e.g., be selected to be d_{PPG} = 350 ms. The estimating of the estimated initial time delay t_{nextR} may, e.g., comprise subtracting the estimated trigger delay from the estimated cardiac cycle length. Furthermore, a predefined safety time period d_{safe} may be subtracted, e.g., 100 ms and/or a time period corresponding to two cardiac phases. The time delay t_{nextR} used for the time-delayed triggering after the detection of the PPG trigger may, e.g., be t_{nextR} = t_{RR} - d_{PPG} - d_{safe}. The safety time period d_{safe}, e.g., d_{safe} = 100 ms, may, e.g., be subtracted in addition for ensuring that the pulse sequence is indeed started before of a ventricular contraction of the ventricular systole of the next cardiac cycle.

A start time of the time-delayed triggering of a pulse sequence for acquiring the magnetic resonance imaging data may, e.g., be kept or may, e.g. be intended to be kept at a constant time period in form of the predefined safety time period d_{safe} before the next main ventricular depolarization, corresponding to an R-peak in an ECG. For example, the start time of the time-delayed triggering of a pulse sequence may be kept at about 100 ms and/or two cardiac phases before the next main ventricular depolarization. This may, e.g., be achieved by one or more of the following measures: a continuously updating of the safety time period d_{safe}, a continuously updating of an estimate of the cardiac cycle length t_{RR}, and a continuously updating of an estimate of the PPG trigger delay d_{PPG}. Thereby, the time delay t_{nextR} = t_{RR} - d_{PPG} - d_{safe} used for the time-delayed triggering may be continuously updated.

Updating the time delay and using the updated time delay for a time-delayed further triggering of a further magnetic resonance imaging data acquisition may, e.g., enable a further adjusting of the time delay to changes of the subject's cardiac cycle. The time delay may, e.g., be updated continuously using for each further update further magnetic resonance imaging data acquired by a further time-delayed magnetic resonance imaging data acquisition. An updated time delay may, e.g., be used for a time-delayed triggering of a next magnetic resonance imaging data acquisition or a magnetic resonance imaging data acquisition after the next magnetic resonance imaging data acquisition relative to a magnetic resonance imaging data acquisition, which magnetic resonance imaging data has been used for the updating of the time delay. This may, e.g., depend on how fast the updating is executed.

For example, the further cardiac trigger may be a second cardiac trigger indicative of a start of the second ventricular systole. The time-delayed further triggering of the further magnetic resonance imaging data acquisition may, e.g., be a time-delayed second triggering of a second magnetic resonance imaging data acquisition. The time-delayed second triggering is, e.g., performed before a start of a third ventricular systole of a third cardiac cycle following the second cardiac cycle. The second magnetic resonance imaging data may, e.g., at least cover the third ventricular systole.

For example, the further cardiac trigger may be a later cardiac trigger. For example, the further cardiac trigger may be a third cardiac trigger indicative of the start of a ventricular contraction of the third ventricular systole. The time-delayed further triggering of the further magnetic resonance imaging data acquisition may, e.g., be a time-delayed third triggering of a third magnetic resonance imaging data acquisition. The time-delayed third triggering is, e.g., performed before a start of a fourth ventricular systole of a fourth cardiac cycle following the third cardiac cycle. The third magnetic resonance imaging data may, e.g., at least cover the fourth ventricular systole.

For example, the method further comprises determining a time of a start of the ventricular contraction of the second ventricular systole using the first magnetic resonance imaging data. The determined time of the start of the ventricular contraction of the second ventricular systole is used for determining the updated time delay.

The time of the start of the ventricular contraction of the second ventricular systole may be used as a reference point of time to determine, whether the time delay used for the time-delayed triggering of the first magnetic resonance imaging data acquisition was sufficient. For example, it may be checked, whether the acquisition started within a predefined range, e.g. from 75 ms to 125 ms, before the start of the ventricular contraction of the second ventricular systole. Furthermore, the time of the start of the ventricular contraction of the second ventricular systole may be used for determining updated values used for the updating of the time delay.

For example, the time-delayed first triggering of the first magnetic resonance imaging data acquisition is intended to start a predefined safety time period before the start of the ventricular contraction of the second ventricular systole. The method further comprises determining a time period elapsed between a start of the first magnetic resonance imaging data acquisition and the time of the start of the ventricular contraction of the second ventricular systole. A difference between the determined time period and the predefined safety time period is determined. The determined difference is used for determining the updated time delay.

For example, the updating of the time delay comprises an adjusting of the time delay using the determined difference. For example, the time delay is adjusted to compensate for the difference.

If the difference is positive, i.e., the determined time period is longer than the predefined safety time period, the data acquisition started too early. In order to compensate for this in a next data acquisition, the time delay is increased, e.g., by the determined difference or by a predefined discrete adjustment step for increasing the time delay. This updating may be considered as an adjusting of the safety time period of the currently or most recently used time delay, which is longer than the predefined safety time period. The currently or most recently used safety time period is increased, e.g., by the determined difference or by the predefined discrete adjustment step. Thus, the currently or most recently used safety time period is updated by this adjustment. For example, the updated safety time period corresponds to the predefined safety time period.

If the difference is negative, i.e., the determined time period is shorter than the predefined safety time period, the data acquisition started too late. In order to compensate for this in a next data acquisition, the time delay is decreased, e.g., by the determined difference or by a predefined discrete adjustment step for decreasing the time delay. This updating may be considered as an adjusting of the safety time period of the currently or most recently used time delay, which is shorter than the predefined safety time period. The currently or most recently used safety time period is decreased, e.g., by the determined difference or by the predefined discrete adjustment step. Thus, the currently or most recently used safety time period is updated by this adjustment. For example, the updated safety time period corresponds to the predefined safety time period.

For example, the updated time delay may be determined using an iterative approach. For example, the predefined safety time period is a time period from a range of 125 ms to 75 ms. For example, the predefined safety time period is a time period of 100 ms. For example, the safety time period is adjusted, i.e., decreased or increased, in predefined discrete adjustment steps. For example, the predefined discrete adjustment steps are time steps of 25 ms.

For example, the time delay depends on a trigger delay descriptive of a delay between a start of a ventricular contraction of a ventricular systole and a detecting of a cardiac trigger indicative of a start of the respective ventricular systole. The method further comprises determining a time period elapsed between the time of the start of the ventricular contraction of the second ventricular systole and a detecting of a second cardiac trigger following the first cardiac trigger using the received photoplethysmography data. The second cardiac trigger is indicative of the start of the second ventricular systole. An updated trigger delay is determined using the determined time period. The updated trigger delay is used for determining the updated time delay.

Examples may, e.g., enable an adjusting of the time delay to changes of the trigger delay, i.e., the delay between a start of a ventricular contraction and a detecting of a cardiac trigger indicative of the start of the respective ventricular contraction.

For example, the time delay may be given by a relation comprising the trigger delay and the time delay may be updated by replacing a previous value for the trigger delay with the value of the updated trigger delay. The time delay may, e.g., be given by t_{nextR} = t_{RR} - d_{PPG} - d_{safe} with t_{RR} denoting the cardiac cycle length, d_{PPG} the trigger delay and d_{safe} an additional delay in form of the safety time period. For example, a previously used trigger delay d_{PPG} may be replaced in the aforementioned equation by the updated trigger delay d_{PPG}. In addition, e.g., an extrapolated cardiac cycle length t_{RR} may be determined and used as an updated cardiac cycle length to replace the previous cardiac cycle length t_{RR} in the aforementioned equation. The updated cardiac cycle length t_{RR}, e.g., an extrapolated cardiac cycle length t_{RR}, may be determined using a determined current cardiac cycle length. Furthermore, e.g., the safety time period d_{safe} may be updated as described above.

For example, as soon as a PPG trigger originating from the second systole is determined, it may be determined 1) an update of the cardiac cycle length t_{RR}, e.g. as an extrapolative predictor based on the last five cardiac cycle lengths of the last five cardiac cycles, and 2) an update of the trigger delay d_{PPG}, e.g., from an image based determination of a time between the start of the ventricular contraction of the second ventricular systole and a detecting of a second cardiac trigger. Then the equation t_{nextR} = t_{RR} - d_{PPG} - d_{safe} may be used to update t_{nextR}, i.e., the time delay. Examples may have the beneficial effect of applying a simple model with the parameters cardiac cycle length t_{RR} and trigger delay d_{PPG}, which both are physiologically independent variables. Trying to determine these parameters, an error of predicting a timing of a next heart beat may, e.g., be smaller than in case of an iterative approach. Assuming, e.g., a case with a cardiac cycle length t_{RR} rising linearly over a couple of heart beats, e.g., because a subject relaxes, the extrapolative predictor may be able to predict that a next cardiac cycle length may even be longer. If the extrapolative predictor is right, the aforementioned equation may lead to a very good prediction of a next time delay. An iterative approach may, e.g., just use data of the previous heartbeat and may not be able to perform as well.

For example, the determining of the time of the start of the ventricular contraction of the second ventricular systole comprises reconstructing a sequence of magnetic resonance images depicting successive ventricular states during the second ventricular systole using the first magnetic resonance imaging data. A ventricular state of starting ventricular contraction during the second ventricular systole is identified using the sequence of magnetic resonance images. The time of the start of the ventricular contraction of the second ventricular systole is determined as a time of the ventricular state of starting ventricular contraction during the second ventricular systole.

Examples may, e.g., enable a determining of the time of the start of the ventricular contraction of the second ventricular systole using image processing.

For example, the identifying of the ventricular state of starting ventricular contraction comprises determining sizes of ventricular areas depicted within the magnetic resonance images of the sequence of magnetic resonance images. A first magnetic resonance image of the sequence of magnetic resonance images depicting a ventricular area with a starting reduction of size compared to a size of the ventricular area depicted in a preceding magnetic resonance image is identified. The ventricular state depicted by the identified first magnetic resonance image is identified as the ventricular state of starting ventricular contraction.

For example, the ventricular areas are left ventricular areas, i.e., areas of the left ventricle. For example, the determining of a size of a ventricular area, e.g., a left ventricular area within a magnetic resonance image comprises segmenting an endocardium, e.g., a left endocardium depicted in the magnetic resonance image. The segmented endocardium, e.g., the left endocardium, may, e.g., be closed such that a closed loop is formed. Furthermore, an area enclosed by the resulting closed endocardium is measured. The result of this measuring may provide the size of the ventricular area, e.g., the left ventricular area.

For example, the method further comprises determining a time of a main ventricular depolarization of the second ventricular systole relative to the time of the start of the ventricular contraction. The time of the main ventricular depolarization determined relative to the time of the start of the ventricular contraction is used for assigning time codes to the magnetic resonance images of the sequence of magnetic resonance images reconstructed using the first magnetic resonance imaging data.

Examples may, e.g., provide for magnetic resonance images assigned with time codes, each identifying a time of the cardiac phase depicted in the respective magnetic resonance images relative to the of the main ventricular depolarization, even though an PPG signal is used for the triggering. This time of the main ventricular depolarization corresponds to the time of occurrence of an R-peak in an ECG signal.

For example, the time of the main ventricular depolarization of the second ventricular systole relative to the time of the start of the ventricular contraction is determined using a predefined period of time elapsed between the main ventricular depolarization and the start of contraction. A predefined period of time elapsed between the main ventricular depolarization and the time of start of ventricular contraction is, e.g., selected from a range of 40 ms to 60 ms. The predefined period of time is, e.g., selected to be 50 ms.

For example, each of the magnetic resonance images depicts a cardiac phase. For example, the magnetic resonance imaging data is acquired over a predefined period of time during a magnetic resonance imaging data acquisition. For example, magnetic resonance imaging data is acquired for N images with the predefined period of time T being divided in N phases, i.e., cardiac phases, and each of the N images depicting a cardiac phase of T/N. For example, each magnetic resonance image depicts a cardiac phase of 50 ms duration.

For example, times are determined for all of the magnetic resonance images of the sequence of magnetic resonance. For example, the times are times relative to a reference point of time. For example, the reference point of time is a time of a main ventricular depolarization of the ventricular systole of the respective cardiac cycle. For example, the magnetic resonance images of the sequence of magnetic resonance are annotated with the determined times. For example, time codes are determined for and assigned to all of the magnetic resonance images of the sequence of magnetic resonance, e.g., such that all of the magnetic resonance images are annotated with a time code.

For example, the method further comprises determining a time of a maximum ventricular contraction during the second ventricular systole using the first magnetic resonance imaging data. The time of the main ventricular depolarization of the second ventricular systole relative to the time of the maximum ventricular contraction is determined. The time of the main ventricular depolarization determined relative to the time of the maximum ventricular contraction is used for the assigning of the time codes to the magnetic resonance images of the sequence of magnetic resonance images reconstructed using the first magnetic resonance imaging data.

For example, a maximum ventricular contraction may be identified and used as a reference state for the determining of the time of the main ventricular depolarization, e.g., as an alternative to the start of the ventricular contraction.

For example, the time of the main ventricular depolarization of the second ventricular systole relative to the time of the maximum ventricular contraction is determined using a predefined period of time elapsed between the main ventricular depolarization and the maximum ventricular contraction. A predefined period of time elapsed between the main ventricular depolarization and the time of the maximum ventricular contraction is, e.g., selected from a range of 280 ms to 320 ms. The predefined period of time is, e.g., selected from a range of 290 ms to 310 ms. The predefined period of time is, e.g., selected to be 300 ms.

For example, the determining of the time of the maximum ventricular contraction during the second ventricular systole comprises identifying a ventricular state of maximum ventricular contraction during the second ventricular systole using the sequence of magnetic resonance images. A time of the ventricular state of maximum ventricular contraction is determined as the time of the maximum ventricular contraction.

Examples may, e.g., enable a determining of the time of the maximum ventricular contraction of the second ventricular systole using image processing.

For example, the identifying of the ventricular state of maximum ventricular contraction comprises identifying a second magnetic resonance image of the sequence of magnetic resonance images depicting a ventricular area with a smallest size. The ventricular state depicted by the identified second magnetic resonance image is identified as the ventricular state of maximum ventricular contraction.

For example, the ventricular areas are left ventricular areas, i.e., areas of the left ventricle. For example, the determining of a size of a ventricular area, e.g., a left ventricular area within a magnetic resonance image comprises segmenting an endocardium, e.g., a left endocardium depicted in the magnetic resonance image. The segmented endocardium, e.g., the left endocardium, may, e.g., be closed such that a closed loop is formed. Furthermore, an area enclosed by the resulting closed endocardium is measured. The result of this measuring may provide the size of the ventricular area, e.g., the left ventricular area.

For example, the time delay further depends on a cardiac cycle length. The updating of the time delay comprises using a time interval between the first cardiac trigger and the second cardiac trigger, which are comprised by the received photoplethysmography data, for determining a current cardiac cycle length. The current cardiac cycle length is used for determining an updated cardiac cycle length. The updated cardiac cycle length is used for determining the updated time delay.

Example may take into account an adjusting of the cardiac cycle length, e.g., in addition to an adjusting of the trigger delay, for updating the time delay.

For example, the current cardiac cycle length is used for extrapolating an estimated cardiac cycle length, which is used for updating the time delay. For example, the estimated cardiac cycle length may be extrapolated using the last m, e.g., m = 5, cardiac cycle lengths determined. The current cardiac cycle length may, e.g., be used to update the extrapolation. An oldest cardiac cycle lengths may be neglected and the current cardiac cycle length as a most recent cardiac cycle length may be used for the extrapolation. An estimated cardiac cycle length t_{RR} resulting from the extrapolation may, e.g., be used to determine the updated time delay t_{nextR} using the relation t_{nextR} = t_{RR} - d_{PPG} - d_{safe} with d_{PPG} denoting the trigger delay and d_{safe} an additional delay.

For example, the photoplethysmography data is received as a continuous data stream. For example, the photoplethysmography data stream is consciously processed for detecting cardiac triggers indicative of starts of ventricular contractions of ventricular systoles during cardiac cycles. For example, the photoplethysmography data stream is consciously processed for monitoring cardiac cycle lengths.

For example, magnetic resonance imaging data acquisitions are magnetic resonance imaging data acquisitions for different slices of the heart over time. For example, magnetic resonance imaging data acquisitions are acquisitions over a period of time long enough to cover at least a ventricular systole of a heart cycle. For example, magnetic resonance imaging data acquisitions are acquisitions over a period of time long enough to cover the ventricular systole and at least part of a ventricular diastole following the ventricular systole.

For example, a myocardial strain encoding, acquisition and evaluation of the slices is executed using the acquired magnetic resonance imaging data.

For example, the method further comprises determining the time delay using the cardiac cycle length, i.e., the time delay used for the time-delayed first cardiac triggering. The determining of the time delay comprises reducing the cardiac cycle length by a reduction time period sufficient long for ensuring the time-delayed first triggering, for which the cardiac cycle length the time delay is used, resulting in the first magnetic resonance imaging data acquisition being started before the start of the second ventricular systole.

For example, the reduction time period comprises the trigger delay and the predefined safety time period.

For example, the time delay t_{nextR} is determined using the relation t_{nextR} = t_{RR} - d_{PPG} - d_{safe} with t_{RR} denoting the cardiac cycle length, d_{PPG} the trigger delay, and d_{safe} an additional delay, i.e., a safety time period. The reduction time period may, e.g., be given by d_{PPG} + d_{safe}.

For example, the safety time period is selected from a range of 150 ms to 50 ms. For example, the safety time period is selected from a range of 125 ms to 75 ms. For example, the safety time period is selected time to be 100 ms.

For example, the safety time period is selected from a range of one to three cardiac phases covered by three to one magnetic resonance imaging data acquisitions. For example, the safety time period is two cardiac phases covered by two magnetic resonance imaging data acquisitions.

For example, the method further comprises determining the cardiac cycle length using the photoplethysmography data, which is descriptive of cardiac cycle lengths of the subject.

For example, the determining of the cardiac cycle length comprises extrapolating the cardiac cycle length from a plurality of cardiac cycle lengths of the subject described by the photoplethysmography data.

For example, time intervals between cardiac triggers comprised by the photoplethysmography data are used as cardiac cycle lengths of the subject for determining the cardiac cycle length. For example, the most recent m time intervals between cardiac triggers before detecting the first cardiac trigger are used for extrapolating the cycle length.

For example, the extrapolated cardiac cycle length is used as an updated cardiac cycle length. For example, the determining of the updated cardiac cycle length comprises determining a current cardiac cycle length of the first cardiac cycle. For example, the determining of the current cardiac cycle length of the first cardiac cycle comprises determining an interval between the first and second cardiac trigger.

For example, the determining of the updated cardiac cycle length comprises updating the cardiac cycle length, i.e., the previous extrapolation based on the plurality of cardiac cycle lengths of the subject. The previous extrapolation is, e.g., updated with the determined cardiac cycle length of the first cardiac cycle, i.e., the current cardiac cycle length. Updating the extrapolation may, e.g., comprise excluding an oldest cardiac cycle length, e.g., an oldest time interval between cardiac triggers, from the extrapolation and using instead the current cardiac cycle length of the first cardiac cycle.

For example, the method further comprises selecting the trigger delay from an upper end of a representative distribution of measured trigger delays.

For example, the method further comprises for further magnetic resonance imaging data acquisitions determining updated cardiac cycle lengths and determining updated time delays using the updated cardiac cycle lengths.

For example, a continuously updating of the cardiac cycle length is implemented with the updated cardiac cycle lengths being used for a continuously updating of the time delay.

For example, the method further comprises for further magnetic resonance imaging data acquisitions determining updated trigger delays and determining the updated time delays using the updated trigger delays.

For example, a continuous updating of the trigger delay is implemented with the updated trigger delays being used for a continuously updating of the time delay.

For example, the first magnetic resonance imaging data acquisition comprises executing a SENC pulse sequence for the acquisition. For example, the further magnetic resonance imaging data acquisition comprises executing the SENC pulse sequence for the acquisition. For example, all the magnetic resonance imaging data acquisitions comprise executing the SENC pulse sequence for the acquisitions. Strain ENCoded (SENC) MR imaging uses an MR pulse sequence that enables a quantitatively measuring of a through-plane strain, i.e., the through-plane mechanical contraction or relaxation of the myocardial muscle in each image pixel of magnetic resonance images reconstructed using magnetic resonance imaging data acquired with the SENC pulse sequence. The main is to encode a through-plane phase ramp, e.g. n wraps across the slice thickness, into the muscle directly after a main ventricular depolarization at the beginning of the ventricular systole. The temporal variation of the strain of the muscle during the systolic motion changes the spatial frequency of this phase ramp, because encoded spins are physically displaced by the muscular contraction. Directly before the acquisition different through-plane gradient rewinders are applied which recover the full magnetic resonance signal if they match the new spatial frequency and less signal due to through-plane dephasing if not. This is used to determine the through-plane strain in percent in multiple cardiac phases, e.g., of about 50ms duration, covering the ventricular systole and, e.g., part of the ventricular diastole.

The clinical value of this information lies in the fact that the muscular contraction starts to decrease locally long before cardiac diseases lead to a significant change of routinely used clinical cardiac function parameters of more global nature as the left ventricular ejection fraction, i.e., the percentage of blood ejected from the ventricle. This early detection capability, the non-use of contrast agents or physiological stress agents, the very short duration of a SENC scan of, e.g., maximally two breath holds, and recent advances in quantitative evaluation and clinical representation of the strain data makes SENC increasingly interesting for quick clinical evaluation of cardiac function.

SENC MRI measures myocardial contraction and may allow earlier detection of many cardiac diseases. However, PPG triggers may be detected too late for triggering a SENC MRI data acquisition in time for a current ventricular systole, for which the PPG trigger is detected. Examples proposed to delay a triggering of the SENC MRI data acquisition to acquire the magnetic resonance imaging data in the next ventricular systole rather than in the current ventricular systole. A time delay used for the time delayed triggering may, e.g., be continuously adjusted. For example, image processing may be used to continuously adjust the required delay during acquisition and/or to annotate image times regarding an estimated time of main ventricular depolarization corresponding to an R-peak time in ECG. Finally, all magnetic resonance images reconstructed using the acquired magnetic resonance imaging data may, e.g., be fed into the evaluation and representation of regional cardiac strain of the heart of the subject.

An exemplary method using a SENC pulse sequences with an PPG triggering may, e.g., comprise:
1. Wait after a detection of a current PPG trigger until about 100ms before a next main ventricular depolarization corresponding to a next R-peak in ECG.
2. Start the SENC pulse sequence time-delayed to acquire multiple cardiac phases to cover the next ventricular systole and, e.g., part of the ventricular diastole. The multiple cardiac phases correspond to multiple magnetic resonance images, which can be reconstructed from the magnetic resonance data acquired of the respective cardiac phases. Further, the multiple cardiac phases are acquired for a currently selected slice of the heart.
3. Find a time of maximal contraction by image processing of all cardiac phases of a current slice and estimate the time of the preceding main ventricular depolarization, i.e., R-peak, from this time. Alternative a time of a start of the contraction may be determined by image processing of all cardiac phases of the current slice and the time of the preceding main ventricular depolarization, i.e., R-peak, estimated from this time.
4. Annotate all magnetic resonance images, i.e., cardiac phase images, with a time code descriptive of a timing of the respective cardiac phase images relative to the time of the preceding main ventricular depolarization. The method may be continued with step 1. for a next slice.
5. Finally, perform a myocardial strain evaluation of all slices. For the myocardial strain evaluation time codes of the images may be used, e.g., to identify the timing of the myocardial strain depicted in the images relative to the main ventricular depolarization, i.e., R-peak.

For delaying the triggering of the SENC pulse sequence after detection of the cardiac trigger to the next ventricular systole, a cardiac cycle length may be estimated. The cardiac cycle length may, e.g., correspond to a length of an RR-interval t_{RR}. The cardiac cycle length may, e.g., be determined based on time intervals between the last m PPG triggers detected using the photoplethysmography data. For example, m may be selected to be m = 5. An initial PPG trigger delay d_{PPG} may, e.g., be estimated to lie at an upper end of a histogram of a plurality of known, e.g., measured, PPG trigger delays. The plurality of known PPG trigger delays may, e.g., be measured for a representative group of subjects. For example, the initial PPG trigger delay may, e.g., be selected to be d_{PPG} = 350 ms. A time delay t_{nextR} used for the time-delayed triggering after the detection of the PPG trigger may, e.g., be t_{nextR} = t_{RR} - d_{PPG} - d_{safe}. The d_{safe} is a predefined safety time period, e.g., of 100 ms, and may be subtracted in addition for ensuring that the SENC pulse sequence is indeed started before of a ventricular contraction of the ventricular systole of the next cardiac cycle.

The determining of a time of maximal contraction during a ventricular systole may, e.g., comprise an image processing. Using a SENC pulse sequence, at least two types of magnetic resonance images may be reconstructed, which are typically referred to as low tuning (LT) and high tuning (HT) images. The LT images may comprise mainly anatomical information of a shape of the ventricle. For example, all cardiac phases of a slice may be used to determine the time of maximal contraction. This may, e.g., be done using image processing. For all cardiac phase images, e.g., a left endocard depicted therein may be segmented, the segmented left endocards may be closed to enclose the left ventricular areas, and the left ventricular areas enclosed by the closed left endocards may be measured. The measured left ventricular areas may be used to find a cardiac phase with a minimal ventricular area and to define this cardiac phase as the time of maximal contraction. This time of maximal contraction corresponds to a minimal left ventricular volume.

A time between a main ventricular depolarization, e.g., corresponding to an R-peak in an ECG, and the maximal contraction may, e.g., be estimated to be approximately 280 ms to 320 ms. This time may, e.g., vary between individuals, but may be assumed to typically fall within this range.

Similarly, image processing may, e.g., be used to find a cardiac phase with an onset of a cardiac motion at the beginning of the ventricular systole.

A time between a main ventricular depolarization, e.g., corresponding to an R-peak in an ECG, and the start of a contraction may, e.g., be estimated to be approximately 40 ms to 60 ms. This time may, e.g., vary between individuals, but may be assumed to typically fall within this range.

A start time of the time-delayed triggering of a pulse sequence, e.g., a SENC pulse sequence, for acquiring the magnetic resonance imaging data may, e.g., be kept at a constant time period before the next main ventricular depolarization, corresponding to an R-peak in an ECG. For example, the start time of the time-delayed triggering of a pulse sequence may be kept at about 100 ms and/or two cardiac phases before the next main ventricular depolarization. This may, e.g., be achieved by two measures: a continuous updating of the estimate of the cardiac cycle length t_{RR} and a continuous updating of an estimate of the PPG trigger delay d_{PPG}.

An adaptive loop over for adapting a time delay for a time-delayed triggering of multiple slices, i.e., of multiple magnetic resonance imaging data acquisitions may, e.g., comprise:
1. Estimate a PPG trigger delay d_{PPG} at an upper end of a histogram of a plurality of known PPG trigger delays, e.g., d_{PPG} = 350ms.
2. Estimate or update a cardiac cycle length t_{RR} using time intervals determined between the last m detected PPG triggers, e.g., m = 5.
3. After a detecting of a PPG trigger wait for a time delay t_{nextR} = t_{RR} - d_{PPG} - d_{safe}. The additional time period d_{safe} may, e.g., be 100 ms or/and two cardiac phases.
4. Execute a pulse sequence, e.g., a SENC pulse sequence with strain encoding and acquisition of multiple cardiac phases to cover at least a ventricular systole and, e.g., part of a ventricular diastole.
5. Evaluate a ventricular contraction of all cardiac phases of a current slice to determine a magnetic resonance image with a beginning of a systolic motion. For example, d_{PPG} is increased to decrease t_{nextR}, if the systolic motion starts earlier than d_{safe} after the beginning of the first phase. This may, e.g., at a phase n < 3. For example, d_{PPG} is decreased to increase t_{nextR}, if the systolic motion starts later than d_{safe} after the beginning of the first phase. This may, e.g., at a phase n > 3. Adjustment steps for adjusting are d_{PPG} may, e.g., correspond to half a cardiac phase and/or be 25 ms.
   As an alternative to the iterative approach described above, e.g., the trigger delay d_{PPG} descriptive of the delay between a start of a ventricular contraction and the detecting of the cardiac trigger may be determined using the magnetic resonance image with the beginning of a systolic motion and the received photoplethysmography data. The trigger delay d_{PPG} may, e.g., be used for updating the time delay using the relation t_{nextR} = t_{RR} - d_{PPG} - d_{safe}.
6. A ventricular contraction of all cardiac phases of the current slice may be evaluated to determine a time of a maximal contraction and to calculate a time of a last main ventricular depolarization, e.g., corresponding to an R-peak in an ECG, by the time of the maximal contraction. For example, the time of a last main ventricular depolarization may be estimated to be 300 ms before the time of the maximal contraction.
   Alternatively, e.g., the time of the start of the ventricular contraction may be used to calculate the time of the last main ventricular depolarization, e.g., corresponding to an R-peak in an ECG. For example, the time of a last main ventricular depolarization may be estimated to be 50 ms before the time of the start of the ventricular contraction.
7. Annotate time codes to the reconstructed magnetic resonance images, each identifying a time of a cardiac phase depicted by the respective magnetic resonance image. The annotated time being a time elapsed since the estimated time of the last main ventricular depolarization.
8. Proceed with step 2 above to acquire magnetic resonance imaging data, e.g., of a next slice through the heart.

After the acquisition of magnetic resonance imaging data has been finished for all the slices of a plurality of slices, a myocardial strain evaluation of the plurality of slices may be performed.

In an example, a computer program for synchronizing magnetic resonance imaging data acquisitions of a heart of a subject with a cardiac cycle of the heart using photoplethysmography data of the subject is disclosed. The computer program comprises machine executable instructions for execution by a computational system. Execution of the machine executable instructions causes the computational system to perform any of the examples of the method for synchronizing magnetic resonance imaging data acquisitions of a heart of a subject with a cardiac cycle of the heart using photoplethysmography data of the subject described herein. For example, the method comprises receiving the photoplethysmography data. A first cardiac trigger is detected using the received photoplethysmography data. The first cardiac trigger is indicative of a start of a first ventricular systole of a first cardiac cycle. In response to the detecting of the first cardiac trigger, a time-delayed first triggering of a first magnetic resonance imaging data acquisition is performed before a start of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

In an example, a medical system comprises a computational system for synchronizing magnetic resonance imaging data acquisitions of a heart of a subject with a cardiac cycle of the heart using photoplethysmography data of the subject. The computational system comprises a memory storing machine executable instructions. Execution of the machine executable instructions causes the computational system to perform any of the examples of the method for synchronizing magnetic resonance imaging data acquisitions of a heart of a subject with a cardiac cycle of the heart using photoplethysmography data of the subject described herein. For example, the method comprises receiving the photoplethysmography data. A first cardiac trigger is detected using the received photoplethysmography data. The first cardiac trigger is indicative of a start of a first ventricular systole of a first cardiac cycle. In response to the detecting of the first cardiac trigger, a time-delayed first triggering of a first magnetic resonance imaging data acquisition is performed before a start of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

For example, the medical system further comprises an optical sensor configured for acquiring the photoplethysmography data. The machine executable instructions further are configured for controlling the optical sensor to acquire the photoplethysmography data.

For example, the medical system further comprises a magnetic resonance imaging system. The machine executable instructions further are configured for controlling the medical imaging system to execute the magnetic resonance imaging data acquisitions.

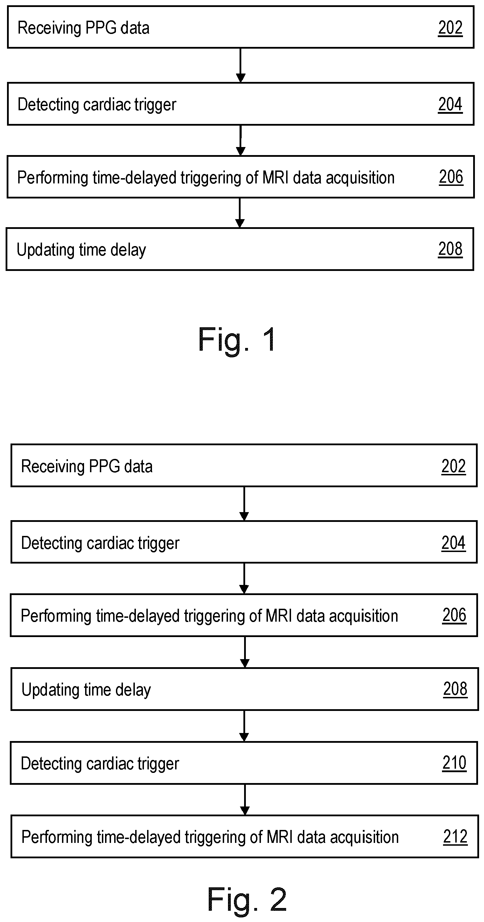

Fig. 1 shows an exemplary method for synchronizing magnetic resonance imaging data acquisitions of a heart of a subject with a cardiac cycle of the heart using photoplethysmography data of the subject. In block 202, the photoplethysmography data is received. In block 204, a cardiac trigger is detected using the received photoplethysmography data. The cardiac trigger is indicative of a start of a first ventricular systole of a first cardiac cycle. In block 206, in response to the detecting of the cardiac trigger, a time-delayed triggering of a magnetic resonance imaging data acquisition is performed before a start of a second ventricular systole of a second cardiac cycle following the first cardiac cycle. The triggering is time-delayed relative to the detecting of the cardiac trigger using a time delay. The magnetic resonance imaging data at least covers the second ventricular systole. In block 208, the time delay is updated to provide an updated time delay. The updated time delay resulting from block 208 is used for performing a time-delayed further triggering of a further magnetic resonance imaging data acquisition in response to detecting a further cardiac trigger using the received photoplethysmography data. The further triggering is time-delayed relative to the detecting of the further cardiac trigger using the updated time delay. For example, the updated time delay resulting from block 208 is used for performing a time-delayed second triggering of a second magnetic resonance imaging data acquisition in response to detecting the second cardiac trigger. The second triggering is time-delayed relative to the detecting of the further cardiac trigger using the updated time delay.

Fig. 2 shows an exemplary method for synchronizing magnetic resonance imaging data acquisitions of a heart of a subject with a cardiac cycle of the heart using photoplethysmography data of the subject. In block 202, the photoplethysmography data is received. In block 204, a first cardiac trigger is detected using the received photoplethysmography data. The first cardiac trigger is indicative of a start of a first ventricular systole of a first cardiac cycle. In block 206, in response to the detecting of the first cardiac trigger, a time-delayed first triggering of a first magnetic resonance imaging data acquisition is performed before a start of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

In block 208, the time delay is updated to provide an updated time delay. The updated time delay resulting from block 208 is used for performing a time-delayed second triggering of a second magnetic resonance imaging data acquisition. In block 210, a second cardiac trigger is detected using the received photoplethysmography data. The second cardiac trigger is indicative of the start of the ventricular contraction of the second ventricular systole of the second cardiac cycle. In block 212, in response to the detecting of the second cardiac trigger, a time-delayed second triggering of a second magnetic resonance imaging data acquisition is performed before a start of a third ventricular systole of a third cardiac cycle following the second cardiac cycle. The second triggering is time-delayed relative to the detecting of the second cardiac trigger using the updated time delay. The second magnetic resonance imaging data at least covers the third ventricular systole.

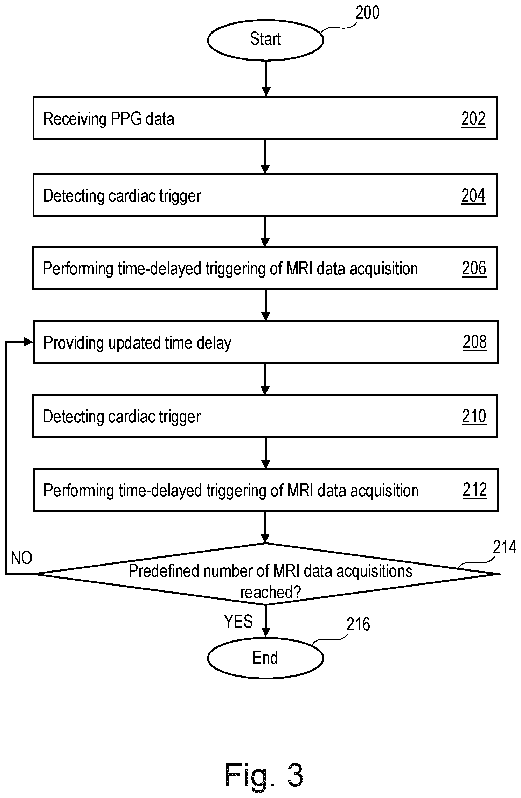

Fig. 3 shows an exemplary method for synchronizing magnetic resonance imaging data acquisitions of a heart of a subject with a cardiac cycle of the heart using photoplethysmography data of the subject. For the synchronizing a time-delayed triggering of the magnetic resonance imaging data acquisitions is used with a time delay, which is continuously updated for adjusting the synchronization. In block 200, the method starts. In block 202, the photoplethysmography data is received. In block 204, a first cardiac trigger is detected using the received photoplethysmography data. The first cardiac trigger is indicative of a start of a first ventricular systole of a first cardiac cycle. In block 206, in response to the detecting of the first cardiac trigger, a time-delayed first triggering of a first magnetic resonance imaging data acquisition is performed before a start of a second ventricular systole of a second cardiac cycle following the first cardiac cycle. The first triggering is time-delayed relative to the detecting of the first cardiac trigger using a time delay. The first magnetic resonance imaging data at least covers the second ventricular systole.

In block 208, the time delay, i.e., the time delay last used, is updated to provide an updated time delay. Initially, e.g., a predefined initial time delay may be used as time delay. Thus, the time delay may, e.g., be continuously updated for adjusting the synchronization of the time-delayed triggering of the magnetic resonance imaging data acquisitions with the cardiac cycle and its variations. In block 210, a current cardiac trigger is detected using the received photoplethysmography data. The current cardiac trigger is indicative of the start of a ventricular contraction of a current ventricular systole of a current cardiac cycle. In block 212, in response to the detecting of the current cardiac trigger, a time-delayed triggering of a next magnetic resonance imaging data acquisition is performed before a start of a next ventricular systole of a next cardiac cycle following the current cardiac cycle. The next triggering is time-delayed relative to the detecting of the current cardiac trigger using the updated time delay. The next magnetic resonance imaging data at least covers the next ventricular systole. In block 214, it is checked, whether a predefined number of magnetic resonance data acquisitions has been reached. In case it is determined in block 214 that the predefined number of magnetic resonance data acquisitions has been reached the method ends in block 216. In case, it is determined in block 214 that the predefined number of magnetic resonance data acquisitions has not yet been reached, the method continues in block 208 with providing an updated time delay. With this updated time delay a further time-delayed magnetic resonance data acquisition is executed for a ventricular systole of a cardiac cycle after next cardiac. For this purpose, blocks 210 to 214 are repeated with the next cardiac cycle of the preceding execution of blocks 210 to 214 being the current cardiac cycle for the repetition of the cardiac cycle.

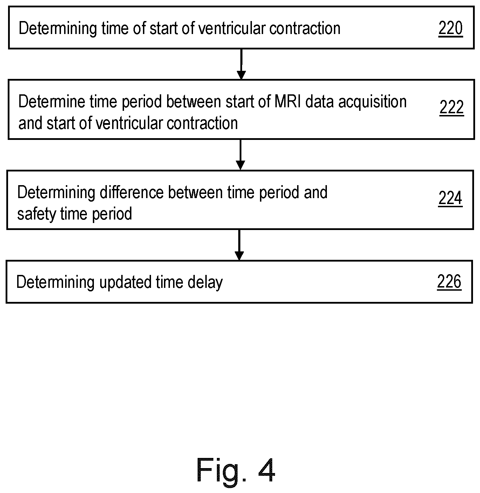

Fig. 4 shows an exemplary method for updating a time delay. A time-delayed triggering of a magnetic resonance imaging data acquisition is, e.g., intended to start a predefined safety time period before a start of a ventricular contraction of a ventricular systole. In block 220, a time of a start of a ventricular contraction of a ventricular systole is determined using currently or most recently acquired magnetic resonance imaging data.

For example, the determining of the time of the start of the ventricular contraction of the respective ventricular systole comprises reconstructing a sequence of magnetic resonance images depicting successive ventricular states during the respective ventricular systole using the acquired magnetic resonance imaging data. For example, a ventricular state of starting ventricular contraction during this ventricular systole is identified using the sequence of magnetic resonance images and determined as the time of the starting ventricular contraction.

For example, sizes of ventricular areas depicted within the magnetic resonance images of the sequence of magnetic resonance images are determined, in order to identify the ventricular state of starting ventricular contraction. A magnetic resonance image of the sequence of magnetic resonance images depicting a ventricular area with a starting reduction of size compared to a size of the ventricular area depicted in a preceding magnetic resonance image may, e.g., be identified. The ventricular state depicted by this identified magnetic resonance image is identified as the ventricular state of starting ventricular contraction.

For example, the ventricular areas being identified in the magnetic resonance images of the sequence of magnetic resonance images are left ventricular areas, i.e., areas of the left ventricle depicted in the respective magnetic resonance images. For example, the determining of a size of a ventricular area, e.g., a left ventricular area within a magnetic resonance image comprises segmenting an endocardium, e.g., a left endocardium depicted in the magnetic resonance image. The segmented endocardium, e.g., the left endocardium, may, e.g., be closed such that a closed loop is formed. Furthermore, an area enclosed by the resulting closed endocardium is measured. The result of this measuring may provide the size of the ventricular area, e.g., the left ventricular area.

In block 222, a time period elapsed between a start of the acquisition of the currently or most recently acquired magnetic resonance imaging data and the time of the start of the ventricular contraction is determined. In block 224, a difference between the determined time period and the predefined safety time period is determined. In block 226, the determined difference is used for determining the updated time delay. For example, a currently or most recently used time delay is adjusted using the determined difference. For example, the time delay is adjusted to compensate for the difference.

If the difference is positive, i.e., the determined time period is longer than the predefined safety time period, the data acquisition started too early. In order to compensate for this in a next data acquisition, the time delay is increased, e.g., by the determined difference or by a predefined discrete adjustment step for increasing the time delay. This updating may be considered as an adjusting of a currently or most recently used safety time period of the currently or most recently used time delay, which is longer than the predefined safety time period. The currently or most recently used safety time period is increased, e.g., by the determined difference or by the predefined discrete adjustment step. Thus, the currently or most recently used safety time period is updated by this adjustment. For example, the updated safety time period corresponds to the predefined safety time period.

If the difference is negative, i.e., the determined time period is shorter than the predefined safety time period, the data acquisition started too late. In order to compensate for this in a next data acquisition, the time delay is decreased, e.g., by the determined difference or by a predefined discrete adjustment step for decreasing the time delay. This updating may be considered as an adjusting of the currently or most recently used safety time period of the currently or most recently used time delay, which is shorter than the predefined safety time period. The currently or most recently used safety time period is decreased, e.g., by the determined difference or by the predefined discrete adjustment step. Thus, the currently or most recently used safety time period is updated by this adjustment. For example, the updated safety time period corresponds to the predefined safety time period.

For example, the predefined safety time period is a time period from a range of 125 ms to 75 ms. For example, the predefined safety time period is a time period of 100 ms. For example, the currently or most recently used safety time period is adjusted, i.e., decreased or increase, in predefined discrete adjustment steps. For example, the predefined discrete adjustment steps are time steps of 25 ms.

The time delay may, e.g., be defined by an estimated cardiac cycle length, e.g., an extrapolated cardiac cycle length, which is reduced by a reduction time period. In case the determined time period is shorter than the reference time period, the reduction time period is, e.g., decreased to increase the updated trigger delay. In case the determined time period is longer than the reference time period, the reduction time period is, e.g., increased to decrease the updated trigger delay. The reduction time period may, e.g., comprise the predefined safety time period. An adjusting of the reduction time period may thus correspond to an adjusting or updating of the safety time period.

For example, the predefined safety time period corresponds to m cardiac phases, i.e., m magnetic resonance images. For example, the reduction time period is increased to decrease the trigger delay, if the ventricular contraction starts at a cardiac phase m < n after the start of the magnetic resonance data acquisition, i.e., in image m < n. In this case, i.e., for m < n, less than m cardiac phases lie between the start of the magnetic resonance data acquisition and the start of the ventricular contraction. For example, the reduction time period is decreased to increase the trigger delay, if the ventricular contraction starts at a cardiac phase m > n after the start of the magnetic resonance data acquisition, i.e., in image m > n. In this case, i.e., for m > n, more than m cardiac phases lie between the start of the magnetic resonance data acquisition and the start of the ventricular contraction. For example, the discrete adjustment steps used for adjusting the trigger delay correspond to half a cardiac phase. For example, the cardiac phase is 50 ms long and the discrete adjustment steps are 25 ms long. For example, the predefined safety time period is two cardiac phases long. For example, the reduction time period is increased to decrease the trigger delay, if the ventricular contraction starts at a cardiac phase m = 3 < n after the start of the magnetic resonance data acquisition, i.e., in image m = 3 < n. For example, the reduction time period is decreased to increase the trigger delay, if the ventricular contraction starts at a cardiac phase m = 3 > n after the start of the magnetic resonance data acquisition, i.e., in image m = 3 > n.

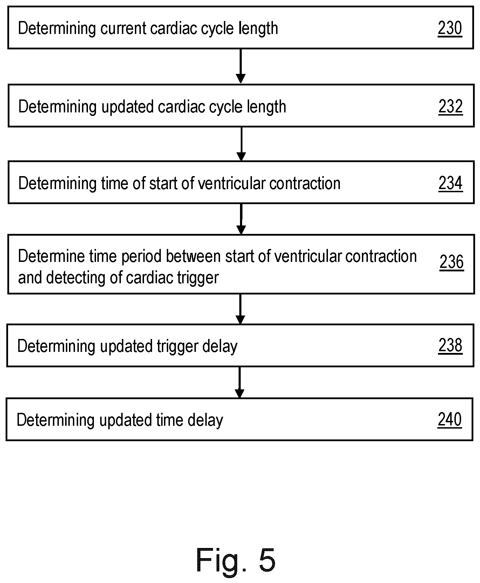

Fig. 5 shows an exemplary method for updating a time delay. The time delay depends, e.g., on a cardiac cycle length. In block 230, a current time interval between cardiac triggers comprised by the received photoplethysmography data is determined. For example, the photoplethysmography data is received as a continuous data stream, which is consciously processed for detecting cardiac triggers indicative of starts of ventricular contractions of ventricular systoles during cardiac cycles. For example, the photoplethysmography data stream is consciously processed for monitoring cardiac cycle lengths of these cardiac cycles.

For example, in response to a detection of a current cardiac trigger, i.e., for a most recently detected cardiac trigger, a time interval between this current cardiac trigger and a detected cardiac trigger preceding the current cardiac trigger, i.e., a cardiac trigger detected immediately preceding the most recently detected cardiac trigger, may be determined as the current time interval using received photoplethysmography data. This current time interval represents a current or most recently detected cardiac cycle length.

In block 232, this current cardiac cycle length is used for determining an updated cardiac cycle length. The updated cardiac cycle length is used in block 240 for updating the time delay, i.e., determining an updated time delay.

The updated time delay may, e.g., be defined using an updated cardiac cycle length in form of an extrapolated cardiac cycle length taking into account the current cardiac cycle length determined in block 230. The extrapolation of the cardiac cycle length to be used for determining the updated time delay may, e.g., use a plurality of the m most recent cardiac cycle lengths including the current cardiac cycle length determined in block 230. For example, m = 5 may be used.

The updated time delay may, e.g., be defined by the updated cardiac cycle length, e.g., in form of the extrapolated cardiac cycle length, which is reduced by a reduction time period sufficient long for ensuring that a time-delayed triggering using the respective time delay is executed before the start of a ventricular systole of a cardiac cycle immediately following a cardiac cycle, for which a cardiac trigger causing the time-delayed triggering has been detected.

The time delay may, e.g., further depend on a trigger delay descriptive of a delay between a start of a ventricular contraction of a ventricular systole and a detecting of a cardiac trigger indicative of a start of the respective ventricular contraction of the respective ventricular systole. For example, a reduction time period comprised by a definition of the time delay may depend on the trigger delay. In block 234, a time of a start of a ventricular contraction of a ventricular systole is determined using currently or most recently acquired magnetic resonance imaging data.

For example, the determining of the time of the start of the ventricular contraction of the respective ventricular systole comprises reconstructing a sequence of magnetic resonance images depicting successive ventricular states during the respective ventricular systole using the acquired magnetic resonance imaging data. For example, a ventricular state of starting ventricular contraction during this ventricular systole is identified using the sequence of magnetic resonance images and determined as the time of the starting ventricular contraction.

For example, sizes of ventricular areas depicted within the magnetic resonance images of the sequence of magnetic resonance images are determined, in order to identify the ventricular state of starting ventricular contraction. A magnetic resonance image of the sequence of magnetic resonance images depicting a ventricular area with a starting reduction of size compared to a size of the ventricular area depicted in a preceding magnetic resonance image may, e.g., be identified. The ventricular state depicted by this identified magnetic resonance image is identified as the ventricular state of starting ventricular contraction.

For example, the ventricular areas being identified in the magnetic resonance images of the sequence of magnetic resonance images are left ventricular areas, i.e., areas of the left ventricle depicted in the respective magnetic resonance images. For example, the determining of a size of a ventricular area, e.g., a left ventricular area within a magnetic resonance image comprises segmenting an endocardium, e.g., a left endocardium depicted in the magnetic resonance image. The segmented endocardium, e.g., the left endocardium, may, e.g., be closed such that a closed loop is formed. Furthermore, an area enclosed by the resulting closed endocardium is measured. The result of this measuring may provide the size of the ventricular area, e.g., the left ventricular area.

In block 236, a time period is determined, which elapsed between the time of the start of the ventricular contraction of the ventricular systole and the detecting of the cardiac trigger indicative of the start of the respective ventricular contraction of the respective ventricular systole. For example, each of the magnetic resonance images depicts a cardiac phase of a predefined length. Thus, each of the magnetic resonance images of the sequence of magnetic resonance images may represent a cardiac phase of a predefined length. In case an n-th magnetic resonance image within the sequence of magnetic resonance images is identified as the magnetic resonance images depicting a ventricular area with a starting reduction of size, the time period elapsed between the start of the respective magnetic resonance imaging data acquisition, i.e., the time of the first magnetic resonance image within the sequence of magnetic resonance images, and the time of the start of the ventricular contraction of the second ventricular systole, i.e., the time of the n-th magnetic resonance image, may, e.g., determined to equal (n-1) times the length of the cardiac phases. In case the magnetic resonance images, e.g., depict cardiac phases of a length of 50 ms, the time period elapsed may be determined to be (n-1) times 50 ms.

The updated trigger delay quantifying a delay between a detecting of a cardiac trigger following a cardiac trigger used for a time-delayed triggering of an acquisition of magnetic resonance imaging data and a start of a ventricular contraction of a ventricular systole for which the respective magnetic resonance imaging data is acquired may, e.g., be determined directly. For the determining, e.g., also the received photoplethysmography data is used. The photoplethysmography data is used for detecting the respective triggers.

The updated cardiac cycle length determined in block 232 and the updated trigger delay determined in block 238 may be used in block 240 for updating the time delay, i.e., determining an updated time delay.

Alternatively, e.g., only the updated cardiac cycle length determined in block 232 or only the updated trigger delay determined in block 238 may be used in block 240 for updating the time delay, i.e., determining an updated time delay.

For example, the exemplary method for updating the time delay of Fig. 5 may be combined with the exemplary method of Fig. 4. In this case, blocks 220 and 226 of Fig. 4 may correspond to blocks 234 and 240 of Fig. 5. The updating of the time delay in block 240 may then in addition use the updated cardiac cycle length determined in block 232 and/or the updated trigger delay determined in block 238, e.g., also use the difference determined in block 224.

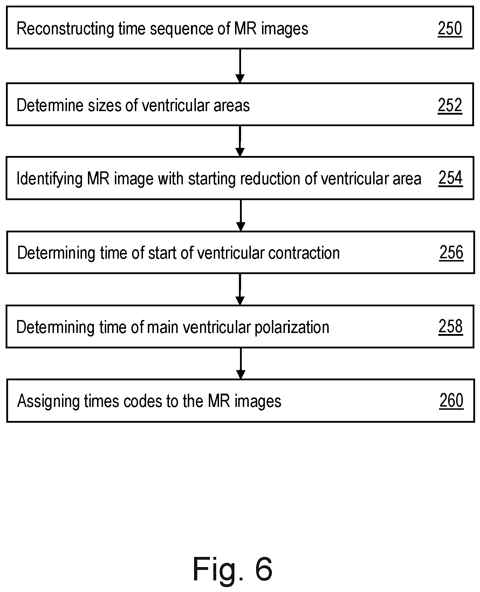

Fig. 6 shows an exemplary method for using magnetic resonance imaging data acquired by a time-delayed triggering. The time-delayed triggering is performed before a start of a ventricular systole of a cardiac cycle such that the magnetic resonance imaging data being acquired at least covers the ventricular systole of the respective cardiac cycle.

In block 250, a sequence of magnetic resonance images is reconstructed using the magnetic resonance imaging data. The sequence is a sequence of magnetic resonance images depicting successive ventricular states at different points in time during the ventricular systole. For example, each of the magnetic resonance images depicts a cardiac phase and a ventricular state during this phase.

For example, the magnetic resonance imaging data is acquired over a predefined period of time during the magnetic resonance imaging data acquisition starting before a start of a ventricular contraction of the ventricular systole and covering at least the respective ventricular systole. For example, magnetic resonance imaging data is acquired for N images with the predefined period of time T being divided in N phases, i.e., cardiac phases, and each of the N images depicting a cardiac phase of T/N. For example, each magnetic resonance image depicts a cardiac phase of 50 ms duration.

Using image processing, specific states of the ventricular systole may be identified. Such a specific state may, e.g., be used to determine a time period elapsed between a start of the magnetic resonance imaging data acquisition and the time of the start of the ventricular contraction of the respective ventricular systole. For example, a time delay used for the time-delayed triggering of the magnetic resonance imaging data acquisition may be adjusted to ensure that the time period elapsed between a start of the magnetic resonance imaging data acquisition and the time of the start of the ventricular contraction of the respective ventricular systole is kept within a predefined range, e.g., within a range of 125 ms to 75 ms. For example, a time delay used for the time-delayed triggering of the magnetic resonance imaging data acquisition may be adjusted to ensure that the time period elapsed between a start of the magnetic resonance imaging data acquisition and the time of the start of the ventricular contraction of the respective ventricular systole is kept at or at least close to 100 ms.

A specific state identified using image processing may, e.g., be used to determine a time shift between the cardiac phases depicted by the magnetic resonance images of the sequence of magnetic resonance images and a reference point of time. The reference point of time may, e.g., be a time of main ventricular polarization. For example, the magnetic resonance images may be assigned with times relative to this reference point in time.

The image processing may, e.g., comprise a determining of sizes of ventricular areas depicted within the magnetic resonance images of the sequence of magnetic resonance images in block 252. This determining of sizes of ventricular areas depicted in the magnetic resonance images may, e.g., comprise segmenting an endocardium in the individual images. The segmented endocardia in the individual images may, e.g., each being closed such that the endocardia form closed loops. Then areas enclosed by the closed endocardia may be measures. The result of these measurements may be sizes of the ventricular areas within the individual images. For example, the ventricular areas are left ventricular areas, i.e., areas of the left ventricle. For example, left endocardia depicted within the images may be segmented, close, and used for defining the areas to be measured. depicted in the magnetic resonance image. Then the result of the measuring may, e.g., be sizes left ventricular areas.

In block 254, a magnetic resonance image of the sequence of magnetic resonance images is identified, which depicts a ventricular area with a starting reduction of size compared to a size of the ventricular area depicted in a preceding magnetic resonance image. The ventricular state depicted by this identified magnetic resonance image may be identified as a ventricular state of starting ventricular contraction. In block 256, a time of the start of the ventricular contraction of the ventricular systole is determined as the time of the identified images, i.e. the time of the cardiac phase depicted by the identified image. This time of the start of the ventricular contraction may, e.g., be used for determining a time period elapsed between a start of the magnetic resonance imaging data acquisition and the time of the start of the ventricular contraction. In case the identified magnetic resonance image is the p-th image of the sequence, the time period elapsed may, e.g., correspond to the duration of p-1 cardiac phases. The time period elapsed between a start of the magnetic resonance imaging data acquisition and the time of the start of the ventricular contraction may, e.g., be used for an adjusting of the time delay used for the time-delayed triggering of the magnetic resonance imaging data acquisition.

In block 258, a time of a main ventricular depolarization of the ventricular systole relative to the time of the start of the ventricular contraction is determined. The time of the main ventricular depolarization of the ventricular systole relative to the time of the start of the ventricular contraction may, e.g., be determined using a predefined period of time elapsed between the main ventricular depolarization and the start of the ventricular contraction. The predefined period of time elapsed between the main ventricular depolarization and the start of the ventricular contraction is, e.g., selected from a range of 40 ms to 60 ms. The predefined period of time is, e.g., selected to be 50 ms.

The time of the main ventricular depolarization may, e.g., be used as a reference point of time relative to which the magnetic resonance images of the sequence of magnetic resonance images are assigned with time codes. For example, the time of the main ventricular depolarization corresponds to a time t = 0.

In block 260, the time of the main ventricular depolarization determined is used for assigning time codes to magnetic resonance images of the sequence of magnetic resonance images reconstructed using the first magnetic resonance imaging data. The magnetic resonance image identified in block 254 is, e.g., assigned with a time code identifying a time t corresponding to predefined period of time elapsed between the main ventricular depolarization and the time of the start of the ventricular contraction. The magnetic resonance image identified in block 254 is, e.g., assigned with a time code t_{q} = 50 ms. The identified magnetic resonance image may, e.g., be the q-th image of the sequence of magnetic resonance. Depending on their relative position to the identified q-th image in the sequence of magnetic resonance images, the other magnetic resonance images may be assigned with time codes. For determining the time codes, the length of the cardiac phases depicted by the magnetic resonance images may be taken into account. A (q-1)-th image preceding the identified magnetic resonance image in the sequence of magnetic resonance images is, e.g., assigned with a time code t_{q-1}, which corresponding to time t_{q} reduced by one cardiac phase, e.g., t_{q-1} = 0 ms, in case of a cardiac phase of 50 ms. A (q+1)-th image succeeding the identified magnetic resonance image in the sequence of magnetic resonance images is, e.g., assigned with a time code t_{q+1}, which corresponding to time t_{q} increased by one cardiac phase, e.g., t_{q+1} = 100 ms, in case of a cardiac phase of 50 ms. For example, time codes are determined for and assigned to all of the magnetic resonance images of the sequence of magnetic resonance, e.g., such that all of the magnetic resonance images are annotated with a time code.

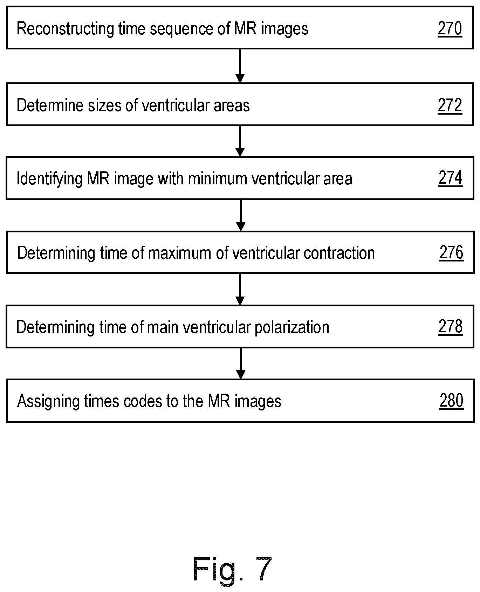

Fig. 7 shows an exemplary method for using magnetic resonance imaging data acquired by a time-delayed triggering. The time-delayed triggering is performed before a start of a ventricular systole of a cardiac cycle such that the magnetic resonance imaging data being acquired at least covers the ventricular systole of the respective cardiac cycle.

In block 270, a sequence of magnetic resonance images is reconstructed using the magnetic resonance imaging data. The sequence is a sequence of magnetic resonance images depicting successive ventricular states at different points in time during the ventricular systole. For example, each of the magnetic resonance images depicts a cardiac phase and a ventricular state during this phase.

For example, the magnetic resonance imaging data is acquired over a predefined period of time during the magnetic resonance imaging data acquisition starting before a start of a ventricular contraction of the ventricular systole and covering at least the respective ventricular systole. For example, magnetic resonance imaging data is acquired for N images with the predefined period of time T being divided in N phases, i.e., cardiac phases, and each of the N images depicting a cardiac phase of T/N. For example, each magnetic resonance image depicts a cardiac phase of 50 ms duration.

Using image processing, specific states of the ventricular systole may be identified. Such a specific state may, e.g., be a state of maximum ventricular contraction during the respective ventricular systole. The specific state identified using image processing may, e.g., be used to determine a time shift between the cardiac phases depicted by the magnetic resonance images of the sequence of magnetic resonance images and a reference point of time. The reference point of time may, e.g., be a time of main ventricular polarization. For example, the magnetic resonance images may be assigned with times relative to this reference point in time.

The image processing may, e.g., comprise a determining of sizes of ventricular areas depicted within the magnetic resonance images of the sequence of magnetic resonance images in block 272. This determining of sizes of ventricular areas depicted in the magnetic resonance images may, e.g., comprise segmenting an endocardium in the individual images. The segmented endocardia in the individual images may, e.g., each being closed such that the endocardia form closed loops. Then areas enclosed by the closed endocardia may be measures. The result of these measurements may be sizes of the ventricular areas within the individual images. For example, the ventricular areas are left ventricular areas, i.e., areas of the left ventricle. For example, left endocardia depicted within the images may be segmented, close, and used for defining the areas to be measured. depicted in the magnetic resonance image. Then the result of the measuring may, e.g., be sizes left ventricular areas.

In block 274, a magnetic resonance image of the sequence of magnetic resonance images is identified, which depicts a ventricular area with a smallest size. The ventricular state depicted by this identified magnetic resonance image may be identified as a ventricular state of maximum ventricular contraction. In block 276, a time of the maximum ventricular contraction of the ventricular systole is determined as the time of the identified images, i.e. the time of the cardiac phase depicted by the identified image. This time of the maximum ventricular contraction may, e.g., be used for determining a time period elapsed between a start of the magnetic resonance imaging data acquisition and the time of the maximum ventricular contraction. In case the identified magnetic resonance image is the p-th image of the sequence, the time period elapsed may, e.g., correspond to the duration of p-1 cardiac phases.

In block 278, a time of a main ventricular depolarization of the ventricular systole relative to the time of the start of the ventricular contraction is determined. The time of the main ventricular depolarization of the ventricular systole relative to the time of the maximum ventricular contraction may, e.g., be determined using a predefined period of time elapsed between the main ventricular depolarization and the maximum ventricular contraction. The predefined period of time elapsed between the main ventricular depolarization and the time of the maximum ventricular contraction is, e.g., selected from a range of 280 ms to 320 ms. The predefined period of time is, e.g., selected from a range of 290 ms to 310 ms. The predefined period of time is, e.g., selected to be 300 ms.

The time of the main ventricular depolarization may, e.g., be used as a reference point of time relative to which the magnetic resonance images of the sequence of magnetic resonance images are assigned with time codes. For example, the time of the main ventricular depolarization corresponds to a time t = 0.

In block 280, the time of the main ventricular depolarization determined using the maximum ventricular contraction is used for assigning time codes to magnetic resonance images of the sequence of magnetic resonance images reconstructed using the first magnetic resonance imaging data. The magnetic resonance image depicting the maximum ventricular contraction is, e.g., assigned with a time code identifying a time t corresponding to predefined period of time elapsed between the main ventricular depolarization and the time of the maximum ventricular contraction. The magnetic resonance image depicting the maximum ventricular contraction is, e.g., assigned with a time code t_{q} = 300 ms. The identified magnetic resonance image may, e.g., be the q-th image of the sequence of magnetic resonance. Depending on their relative position to the identified q-th image in the sequence of magnetic resonance images, the other magnetic resonance images may be assigned with time codes. For determining the time codes, the length of the cardiac phases depicted by the magnetic resonance images may be taken into account. A (q-1)-th image preceding the identified magnetic resonance image in the sequence of magnetic resonance images is, e.g., assigned with a time code t_{q-1}, which corresponding to time t_{q} reduced by one cardiac phase, e.g., t_{q-1} = 250 ms, in case of a cardiac phase of 50 ms. A (q+1)-th image succeeding the identified magnetic resonance image in the sequence of magnetic resonance images is, e.g., assigned with a time code t_{q+1}, which corresponding to time t_{q} increased by one cardiac phase, e.g., t_{q+1} = 350 ms, in case of a cardiac phase of 50 ms. For example, time codes are determined for and assigned to all of the magnetic resonance images of the sequence of magnetic resonance, e.g., such that all of the magnetic resonance images are annotated with a time code.

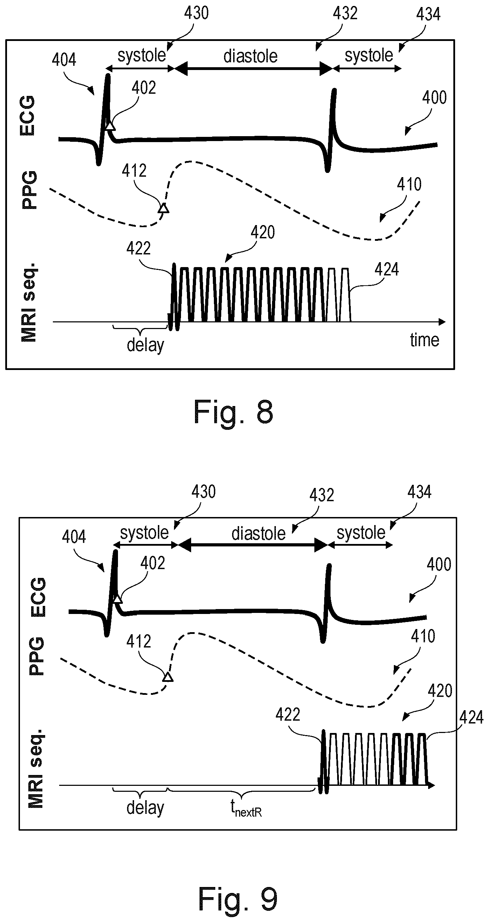

Fig. 8 illustrates an exemplary extra trigger delay occurring when using a PPG based triggering for a magnetic resonance imaging data acquisition. For illustrative purposes, an exemplary ECG signal 400 is shown. The ECG signal 400 comprises an QRS complex 404 describing a ventricular depolarization preceding a ventricular contraction. A highest peak of the QRS complex 404 is an R-peak describing a main ventricular depolarization. For example, when using an ECG signal 440 for triggering a magnetic resonance imaging data acquisition, the R-peak may be used as a cardiac trigger 402 for triggering a magnetic resonance imaging data acquisition at the start of a ventricular systole 430. A magnetic resonance imaging data acquisition (not shown) triggered at this point of time may, e.g., cover the ventricular systole 430. Below the exemplary ECG signal 400, a PPG signal 410 is shown. The PPG signal 410 may, e.g., also comprise a cardiac trigger 412, which is descriptive of the main ventricular depolarization. For example, the cardiac trigger 412 may be the PPG signal 410 value at a point of time at which a tangent to a local minimum of the PPG signal 410 intersects with a tangent to a local maximum of a first derivative of the PPG signal 410. However, this cardiac trigger 412 occurs in the PPG signal 410 with an extra delay relative to an occurrence of the same trigger 402 in the ECG signal 400.

This extra delay may be caused by two effects. Firstly, after the main ventricular depolarization of the ventricular systole 430, indicated by the R-peak of the QRS complex 404 in the ECG signal 400, a blood flush needs to be generated and it needs to travel from the heart to an PPG observation site, e.g., a subject's face. The time required for the generating of the actual blood flush is referred to as the pre-ejection period (PEP). The travel time is referred to as pulse transit time (PTT). The combination of PEP and PTT is referred to as a pulse arrival time (PAT). Secondly, the PPG signal 419 is of a more low-frequent nature than the QRS complex 404, in particular the R-peak, of the ECG signal 400. This may result in some extra algorithmic delay required to robustly identify the cardiac trigger 412 in the PPG signal 410. While this algorithmic delay may be approximately constant and known from the type of image or video processing used for processing the PPG signal as well as from the type of trigger identification, the PAT may in general be patient specific. PAT and algorithmic delay may in combination result in the extra delay. This extra delay may, e.g., be of the order of 150 ms to 350 ms. Triggering a magnetic resonance imaging data acquisition immediately after detecting the cardiac trigger 412 in the PPG signal 410, i.e., executing a magnetic resonance imaging pulse sequence 420 may, e.g., result in a magnetic resonance data acquisition, which mainly covers a ventricular diastole 432. After a tagging pulse 422, the pulses 420 of the pulse sequence 420 cover the ventricular diastole 432. Each of these pulses 420 may correspond to a different cardiac phase and thus to a different magnetic resonance image reconstructable from the acquired magnetic resonance imaging data. This ventricular diastole 432 is the ventricular diastole of the cardiac cycle comprising the ventricular systole 430, for which the cardiac trigger 412 in the PPG signal 410 is detected. However, this detection is too late for enabling a covering of the ventricular systole 430 due to the extra delay. At best some of the pulses 424 at the end of the pulse sequence 420 may cover a start of a next ventricular systole 434 of a next cardiac cycle.

Fig. 9 shows a time-delayed performing of a triggering of a magnetic resonance imaging using a time delay t_{nextR}. In response to a detecting of the cardiac trigger 412 in the PPG signal 410, a time-delayed triggering of the magnetic resonance imaging data acquisition is performed using the time delay t_{nextR}. Thus, the magnetic resonance imaging pulse sequence 420 is executed after the time delay t_{nextR}, which results in a start of the magnetic resonance imaging pulse sequence 420 before a start of the next ventricular systole 434 of the next cardiac cycle following the cardiac cycle comprising the ventricular systole 432 causing the cardiac trigger 412. After a tagging pulse 422, the time-delayed pulse sequence 420 comprises a plurality of pulses 424 covering the ventricular systole 434. The time-delayed pulse sequence 420 may, e.g., further comprise pulses 424 covering part of a ventricular diastole following the ventricular systole 434.

The time delay t_{nextR} used for the time-delayed triggering after the detection of the cardiac trigger 412 may, e.g., be t_{nextR} = t_{RR} - d_{PPG} - d_{safe}. Here, t_{RR} may refer to a cardiac cycle length. The trigger delay d_{PPG} describes a delay between a start of a ventricular contraction and the detecting of the cardiac trigger 412. The ventricular contraction usually starts approximately 50 ms after the time of the main ventricular depolarization corresponding to the R-peak of the QRS complex 404 of the ECG signal 400. Thus, the trigger delay d_{PPG} may, e.g., be approximately 50 ms shorter than the extra trigger delay between the time of the main ventricular depolarization and the time of the detection of the cardiac trigger 412. Thus, the triggering of the magnetic resonance imaging data acquisition may be delayed relative to an occurrence of a cardiac state causing the cardiac trigger 412 in the PPG signal by d_{PPG} + t_{nextR} = t_{RR} - d_{safe}, i.e., by a cardiac cycle length t_{RR}, which is reduced by a safety margin d_{safe}. The safety time period d_{safe} may, e.g., be subtracted in addition for ensuring that the pulse sequence 420 is indeed started before the start of the ventricular contraction of the ventricular systole 434 of the next cardiac cycle. The additional time period d_{safe} may, e.g., be 100 ms and/or two cardiac phases. Using the time delay t_{nextR}, a triggering of the magnetic resonance data acquisition synchronous to a specific state of the cardiac cycle, e.g., a start of the ventricular systole 434 may be enabled.

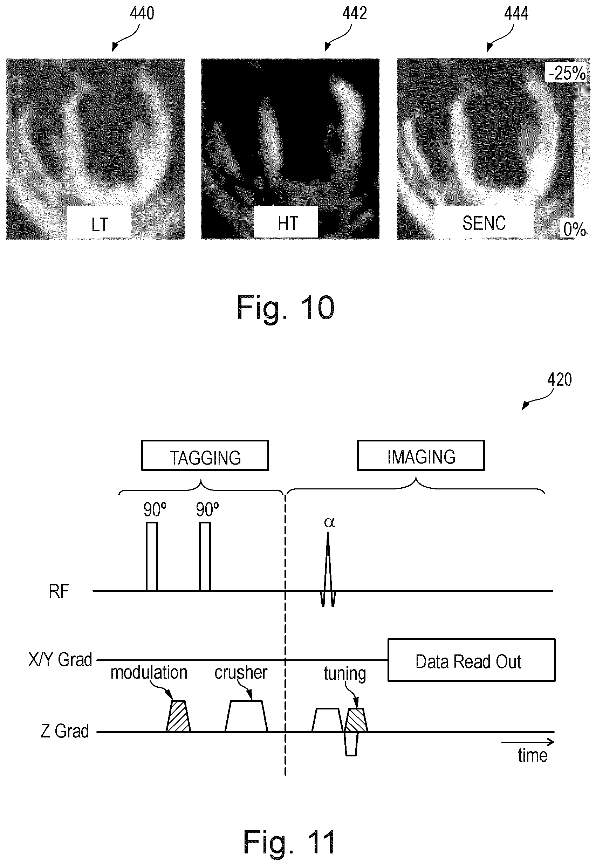

Fig. 10 shows exemplary magnetic resonance images 440, 442, 444, which may be reconstructed using magnetic resonance imaging data acquired using a SENC pulse sequence. For example, an image 440 with low tuning (LT) may be reconstructed. This LT image 440 holds mainly anatomical information of the cardiac shape. Furthermore, an image 442 with high tuning (HT) may be reconstructed. This HT image 442 holds mainly strain information. A SENC image 444 illustrating the strain of the individual anatomical sections of the heart may be is calculated based on a combination of the LT and HT information. For example, the LT image 440 of the SENC image 444 may, e.g., be used for deterring a size of a ventricular area, in particular a left ventricular area at a time of acquisition of the magnetic resonance imaging data used to reconstruct the images 440, 442, 444.

Fig. 11 shows an exemplary pulse sequence 420 in form of an exemplary SENC pulse sequence. A modulation gradient may be applied in the through-plane direction, i.e., z-direction. During the imaging stage of the pulse sequence 420, a tuning gradient may be applied in the z-direction after slice selection and before data read out. In SENC tagging is applied in the through-plane direction creating a stack of magnetization-saturated planes that lie inside and parallel to the image plane. During the cardiac cycle, these parallel tagged planes move closer together or further apart based on tissue contraction or stretching in the through-plane direction, respectively, which affects the tagging (modulation) frequency. At the imaging time point, different images may be acquired with different demodulation (tuning) values. For example, two images are acquired, i.e., low-tuning (LT) and high-tuning (HT) images. The LT image is, e.g., acquired at the same applied tagging frequency to capture signals from static (non-contracting) tissues. The HT image is, e.g., acquired at a higher frequency, e.g., calculated based on slice thickness, applied tagging frequency, and expected strain range, to capture signals from contracting tissues. By combining the information from the LT and HT images, e.g., a color-coded strain map may be obtained that shows strain values on the pixel level.

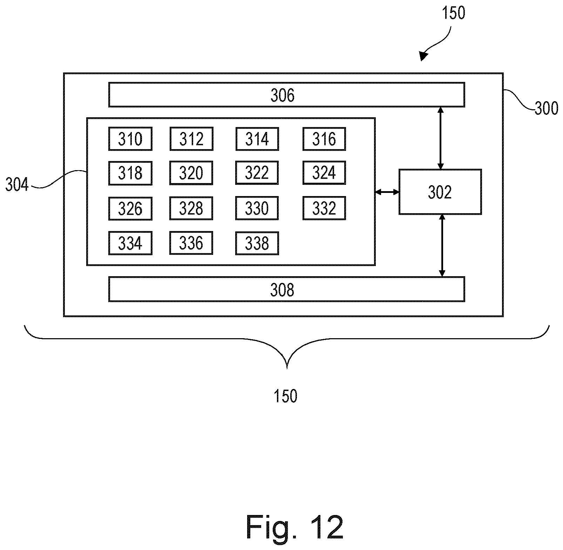

Fig. 12 shows an exemplary computational system 300 of an exemplary medical device 150. The computational system 300 may, e.g., be configured for synchronizing magnetic resonance imaging data acquisitions of a heart of a subject with a cardiac cycle of the heart using photoplethysmography data of the subject.

The computational system 300 is shown as comprising a computational component 302. The computational component 302 is intended to represent one or more processors or processing cores or other computational elements. The computational component 302 is shown as being connected to a hardware interface 306 and a memory 304. The hardware interface 306 may enable the computational component 302 to exchange commands and data with other components, e.g., an optical sensor and/or a magnetic resonance imaging system. The hardware interface 306 may, e.g., enable the computational component 302 to control the optical sensor to acquire optical sensor data 318, e.g., a sequence of optical images. The hardware interface 306 may, e.g., further enable the computational component 302 to control a magnetic resonance imaging system.

The computational system 300 is further shown as being connected to a user interface 308, which may, e.g., enable an operator to control and operate the computational system 300 and via the computational system 300 an optical sensor and/or a magnetic resonance imaging system. The user interface 308 may, e.g., comprise an output and/or input device enabling the operator to interact with the computational system 300. The output device may, e.g., comprise a display device configured for displaying, an PPG signal 320 determined using the optical sensor data 318 acquired with the optical sensor and/or of magnetic resonance images 316 reconstructed using magnetic resonance imaging data 314 acquired using a magnetic resonance imaging system. The input device may, e.g., comprise a keyboard and/or a mouse enabling the operator to insert control commands for controlling the computational system 300 and via the computational system 300 an optical sensor and/or a magnetic resonance imaging system.

The memory 304 is shown as containing machine-executable instructions 310. The machine-executable instructions 310 enable the computational component 302 to perform controlling tasks, such as controlling an optical sensor and/or a magnetic resonance imaging system, to perform numerical tasks, as well as performing various signal data processing tasks, acquiring the PPG signal 320 and/or reconstructing the magnetic resonance images 316. The machine-executable instructions 310 may, e.g., enable the computational component 302 and thus the computational system 300 to execute the methods of any of Fig. 1 to Fig. 7.

The memory 304 is further shown as containing optical sensor data 318 received, e.g., from an optical sensor. The optical sensor data 318 may, e.g., comprise a sequence of optical images of an area of skin of a subject, e.g., of a head of the subject. The memory 304 is further shown as containing a PPG signal 320 determined using the optical sensor data 318, i.e., extracted from the optical sensor data 318.

This PPG signal 320 may be used for a cardiac triggering of a magnetic resonance imaging data acquisition executed using a magnetic resonance imaging system. For this purpose, the memory 304 may further contain a of pulse sequence 312 configured for controlling the magnetic resonance imaging data acquisition, which may be triggered using the PPG signal 320. The pulse sequence 312 may, e.g., be a SENC pulse sequence. The memory 304 is further shown as containing magnetic resonance imaging data 314 acquired using the magnetic resonance imaging system, which is controlled using the one or more sets of pulse sequences 312. Finally, the memory 304 is shown as containing magnetic resonance images 316 reconstructed using the acquired magnetic resonance imaging data 314.

For executing a time delayed acquisition of the magnetic resonance imaging data 314, a time delay 324 may be used. Upon detection of a cardiac trigger 322 within the PPG signal 320, the acquisition of the resonance imaging data 314 may be executed using the time delay 324. The time delay 324 may, e.g., depend on a cardiac cycle length 328 and/or a trigger delay 332. The PPG signal 320 may be used to determine an updated cardiac cycle length 330. The updated cardiac cycle length 330 may, e.g., be an extrapolated cardiac cycle length using cardiac cycle lengths comprised by the PPG signal 320, in particular a current cardiac cycle length. The magnetic resonance imaging data 314 and in particular the magnetic resonance images 316 reconstructed using the acquired magnetic resonance imaging data 314 may be used to determine an updated trigger delay 334. The updated cardiac cycle length 330 and/or the updated trigger delay 334 may be used to determine an updated time delay 326. The memory 304 may, e.g., further contain a definition of a safety time period 336. The time delay t_{nextR} used for a time-delayed triggering after a detection of the PPG trigger may, e.g., be t_{nextR} = t_{RR} - d_{PPG} - d_{safe}, with t_{RR} denoting the cardiac cycle length, d_{PPG} denoting the trigger delay, and d_{safe} denoting the safety time period. Thus, for determining the updated time delay 326, e.g., the updated cardiac cycle length 330 may be used as T_{RR} and/or the updated trigger delay 334 may be used as d_{PPG} in the aforementioned relation. Furthermore, e.g., the safety time period 336 may be updated and the updated safety time period may be used as d_{safe} in the aforementioned relation. The updated time delay 326 may, e.g., be used for a further time-delayed magnetic resonance imaging data acquisition for acquiring additional magnetic resonance imaging data in response to detecting a further cardiac trigger in the PPG signal 320. Furthermore, time codes 338 may be determined, which are descriptive of a time of ventricular states depicted in the magnetic resonance images 316 relative to a reference, e.g., to a time of main ventricular depolarization. The time codes 338 may, e.g., be assigned to the magnetic resonance images 316.

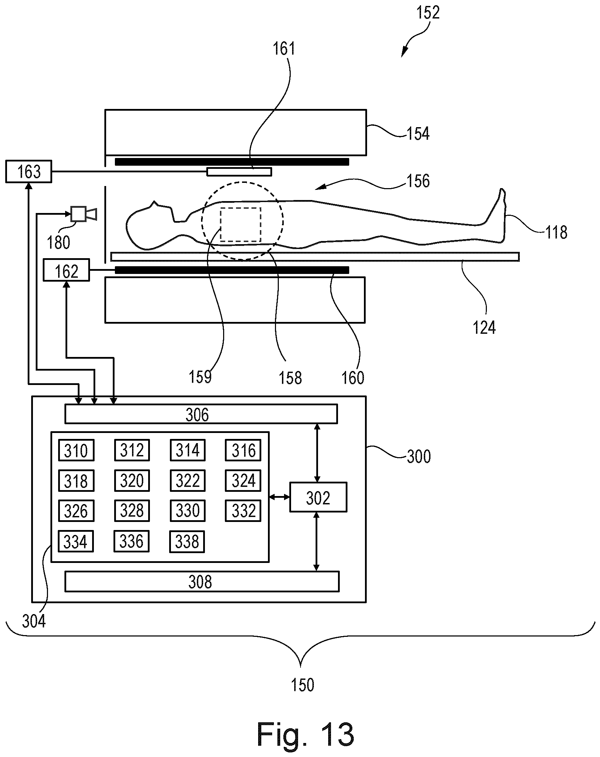

Fig. 13 shows an exemplary medical system 150 comprising a magnetic resonance imaging system 152, an optical sensor 180, and a computational system 300. The medical system 150 may, e.g., be operated using any of the methods of Fig. 1 to Fig. 7. The computational system 300 of Fig. 13 may, e.g., be the computational system 300 of Fig. 12.

The optical sensor 180 may, e.g., be configured for acquiring acquire optical sensor data 318 of skin of a target area of a subject 118. For example, the target area is an area within a head and/or neck region of the subject 118. The target area may, e.g., comprise one or more of the following skin tissue sections of the subject 118: a forehead, a check, a neck, and/or a top region of the head of the subject 118. The top region of the head of the subject 118 may, e.g., comprise one or more of the following: a top frontal section of the head, a top mid-scalp section of the head, a top crown section of the head.

The magnetic resonance imaging system 152 comprised by the medical system 150 is, e.g., configured for acquiring magnetic resonance data 314 from the subject 118 arranged at least partially within a bore 156 of the magnetic resonance imaging system 152. The medical system 150 further comprises the at least one optical sensor 180 configured to acquire the optical sensor data 318.

The magnetic resonance imaging system 152 is being controlled by the hardware interface 306 of the computational system 300. The magnetic resonance imaging system 152 comprises a magnet 154. The magnet 154 is, e.g., a superconducting cylindrical type of magnet with the bore 156 through it. The use of different types of magnets is also possible. For instance, it is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 156 of the cylindrical magnet 154 there is an imaging zone 159, where the magnetic field is strong and uniform enough to perform magnetic resonance imaging. A field of view 158 is shown within the imaging zone 159. The magnetic resonance data is typically acquired for the field of view 158. A subject 118 is shown as being supported by a subject support 124, like an examination table, such that at least a portion of the subject 118, e.g., the chest, is within the imaging zone 159 and the field of view 158.

Within the bore 156 of the magnet 154 there is also a set of magnetic field gradient coils 160 which is used for the acquisition of preliminary magnetic resonance imaging data to spatially encode magnetic spins within the bore 156 of the magnet 154. The magnetic field gradient coils 160 are connected to a gradient controller, i.e., a magnetic field gradient coil power supply 162. The magnetic field gradient coils 160 are intended to be representative. Typically, magnetic field gradient coils 160 contain three separate sets of coils for spatial encoding in three orthogonal spatial directions. The magnetic field gradient power supply 162 supplies current to the magnetic field gradient coils 160. The current supplied to the magnetic field gradient coils 160 is controlled as a function of time and may be ramped or pulsed.

Adjacent to the imaging zone 159 is a radio-frequency antenna 161 arranged for manipulating the orientations of magnetic spins within the imaging zone 159 and for receiving radio transmissions from spins also within the imaging zone 159. The radio-frequency antenna 161may contain multiple coil elements. The radio-frequency antenna 161 is connected to a radio-frequency transceiver 163. The radio-frequency antenna 161 and radio-frequency transceiver 163 may be replaced by separate transmit and receive coils and a separate transmitter and receiver. It is understood that the radio-frequency antenna 161 and the radio-frequency transceiver 163 are representative. The radio-frequency antenna 161 is intended to also represent a dedicated transmit antenna and a dedicated receive antenna. Likewise, the transceiver 163 may also represent a separate transmitter and receivers. The radio-frequency antenna 161 may also have multiple receive/transmit elements and the radio- frequency transceiver 163 may have multiple receive/transmit channels. The transceiver 163 and the gradient controller 162 are shown as being connected to the hardware interface 306 of the computational system 300.

The execution of the machine-executable instructions 310 by the computational system 300 may further cause the computational system 300 to acquire magnetic resonance imaging data 314 using the pulse sequence 312, e.g., a SENC pulse sequence. The acquisition of the magnetic resonance imaging data 314 may be a time-delayed acquisition triggered using the PPG signal 320. For the delaying of the acquisition, e.g., the time delay 324 may be used. The acquired magnetic resonance imaging data 314 is used to reconstruct the magnetic resonance images 316. Additionally or alternatively, the PPG signal 320 may be used to sort, collate, select, and/or annotate the reconstructed magnetic resonance images 316, e.g., to show extracted PPG information or information derived therefrom, such as a cardiac phase, alongside the reconstructed magnetic resonance images 316.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method, or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer-readable medium(s) having computer executable code embodied thereon.

Any combination of one or more computer-readable medium(s) may be utilized. The computer-readable medium may be a computer-readable signal medium or a computer-readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer-readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer-readable-storage medium also refers to various types of recording media capable of being accessed by the computer device via a network or communication link. For example, data may be retrieved over a modem, over the internet, or over a local area network. Computer executable code embodied on a computer-readable medium may be transmitted using any appropriate medium, including but not limited to wireless, wire line, optical fiber cable, RF, etc., or any suitable combination of the foregoing.

A computer-readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer-readable signal medium may be any computer-readable medium that is not a computer-readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine-executable instruction or computer executable code. References to the computational system comprising the example of a `computational system' should be interpreted as possibly containing more than one computational component or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine-executable code or instructions may be executed by multiple computational systems or processors that may be within the same computing device or which may even be distributed across multiple computing devices.

Machine-executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++, or the like and conventional procedural programming languages, such as the "C" programming language or similar programming languages and compiled into machine-executable instructions. In some instances, the computer executable code may be in the form of a high-level language or in a pre-compiled form and be used in conjunction with an interpreter which generates the machine-executable instructions on the fly. In other instances, the machine-executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine-executable instructions or computer program instructions may also be stored in a computer-readable medium that can direct a computer, other programmable data processing apparatus, or other devices to function in a particular manner, such that the instructions stored in the computer-readable medium produce an article of manufacture including instructions which implement the function/act specified in the flowchart and/or block diagram block or blocks.

The machine-executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode Ray Tube (CRT), storage tube, bi-stable display, electronic paper, vector display, flat panel display, Vacuum Fluorescent (VF) display, Light-Emitting Diode (LED) displays, Electroluminescent display (ELD), Plasma Display Panels (PDP), Liquid Crystal Display (LCD), Organic Light-Emitting Diode (OLED) displays, a projector, and head-mounted display.

Magnetic resonance imaging data is defined herein as being the recorded measurements of RF signals emitted by atomic spins using the antenna of a magnetic resonance apparatus, like a magnetic resonance imaging system and/or a head coil device, during a magnetic resonance imaging data. A magnetic resonance image is defined herein as being the reconstructed two- or three-dimensional visualization of anatomic data contained within the magnetic resonance imaging data.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to an advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 118: subject
- 124: support
- 150: medical system
- 152: MRI system
- 154: magnet
- 156: bore of magnet
- 158: field of view
- 159: imaging zone
- 160: magnetic field gradient coils
- 161: radio-frequency antenna
- 162: gradient controller
- 163: radio-frequency transceiver
- 180: optical sensor
- 300: computational system
- 302: computational component
- 304: memory
- 306: hardware interface
- 308: user interface
- 310: machine readable instructions
- 312: pulse sequence
- 314: MRI data
- 316: reconstructed MR images
- 318: optical sensor data
- 320: PPG signal
- 322: cardiac trigger
- 324: time delay
- 326: updated time delay
- 328: cardiac cycle length
- 330: updated cardiac cycle length
- 332: trigger delay
- 334: updated trigger delay
- 336: safety time period
- 338: time codes
- 400: ECG signal
- 402: cardiac trigger
- 404: QRS complex
- 410: PPG signal
- 412: cardiac trigger
- 420: pulse sequence
- 422: tagging pulse
- 424: pulse
- 430: ventricular systole
- 432: ventricular diastole
- 434: next ventricular systole
- 440: LT image
- 442: HT image
- 444: SENC image
- t_{RR}: cardiac cycle length
- d_{PPG}: trigger delay
- d_{safe}: safety time period
- t_{nextR}: time delay

## Claims

1. A method for synchronizing magnetic resonance imaging data acquisitions of a heart of a subject (118) with a cardiac cycle of the heart using photoplethysmography data (320; 410) of the subject (118), the method comprising:
- receiving the photoplethysmography data (320; 410);
- detecting a first cardiac trigger (322; 412) using the received photoplethysmography data (320; 410), the first cardiac trigger (322; 412) being indicative of a start of a first ventricular systole (430) of a first cardiac cycle;
- in response to the detecting of the first cardiac trigger (322; 412), performing a time-delayed first triggering of a first magnetic resonance imaging data (314) acquisition before a start of a ventricular contraction of a second ventricular systole (434) of a second cardiac cycle following the first cardiac cycle, the first triggering being time-delayed relative to the detecting of the first cardiac trigger (322; 412) using a time delay (324), the first magnetic resonance imaging data (314) at least covering the second ventricular systole (434);
- updating the time delay (326) using the acquired first magnetic resonance imaging data (314) to provide an updated time delay (326);
- using the updated time delay (326) for performing a time-delayed further triggering of a further magnetic resonance imaging data acquisition in response to detecting a further cardiac trigger using the received photoplethysmography data (320; 410), the further triggering being time-delayed relative to the detecting of the further cardiac trigger using the updated time delay (326).

2. The method of claim 1, the method further comprising:
- determining a time of a start of the ventricular contraction of the second ventricular systole (434) using the first magnetic resonance imaging data (314);
- using the determined time of the start of the ventricular contraction of the second ventricular systole (434) for determining the updated time delay (334).

3. The method of claim 2, the time-delayed first triggering of the first magnetic resonance imaging data (314) acquisition being intended to start a predefined safety time period before the start of the ventricular contraction of the second ventricular systole (434), the method further comprising:
- determining a first time period elapsed between a start of the first magnetic resonance imaging data (314) acquisition and the time of the start of the ventricular contraction of the second ventricular systole (434);
- determining a difference between the determined first time period and the predefined safety time period,
- using the determined difference for determining the updated time delay (334).

4. The method of any of claims 1 to 2, the time delay (322) depending on a trigger delay (332) descriptive of a delay between a start of a ventricular contraction of a ventricular systole and a detecting of a cardiac trigger indicative of a start of the respective ventricular systole, the method further comprising:
- determining a second time period elapsed between the time of the start of the ventricular contraction of the second ventricular systole (434) and a detecting of a second cardiac trigger following the first cardiac trigger (322; 412) using the received photoplethysmography data (320; 410), the second cardiac trigger being indicative of the start of the second ventricular systole (434);
- determining an updated trigger delay (334) using the determined second time period;
- using the updated trigger delay (334) for determining the updated time delay (326).

5. The method of any of claims 2 to 3, the determining of the time of the start of the ventricular contraction of the second ventricular systole (434) comprising:
- reconstructing a sequence of magnetic resonance images (316) depicting successive ventricular states during the second ventricular systole (434) using the first magnetic resonance imaging data (314);
- identifying a ventricular state of starting ventricular contraction during the second ventricular systole (434) using the sequence of magnetic resonance images (316);
- determining the time of the start of the ventricular contraction of the second ventricular systole (434) as a time of the ventricular state of starting ventricular contraction during the second ventricular systole (434).

6. The method of claim 3, the identifying of the ventricular state of starting ventricular contraction comprising:
- determining sizes of ventricular areas depicted within the magnetic resonance images (316) of the sequence of magnetic resonance images (316);
- identifying a first magnetic resonance image of the sequence of magnetic resonance images (316) depicting a ventricular area with a starting reduction of size compared to a size of the ventricular area depicted in a preceding magnetic resonance image;
- identifying of the ventricular state depicted by the identified first magnetic resonance image as the ventricular state of starting ventricular contraction.

7. The method of any of the claims 2 to 4, the method further comprising:
- determining a time of a main ventricular depolarization of the second ventricular systole (434) relative to the time of the start of the ventricular contraction;
- using the time of the main ventricular depolarization determined relative to the time of the start of the ventricular contraction for assigning time codes (338) to the magnetic resonance images (316) of the sequence of magnetic resonance images (316) reconstructed using the first magnetic resonance imaging data (314).

8. The method of any of previous claims 1 to 6, the method further comprising:
- determining a time of a maximum ventricular contraction during the second ventricular systole (434) using the first magnetic resonance imaging data (314);
- determining the time of the main ventricular depolarization of the second ventricular systole (434) relative to the time of the maximum ventricular contraction;
- using the time of the main ventricular depolarization determined relative to the time of the maximum ventricular contraction for the assigning of the time codes (338) to the magnetic resonance images (316) of the sequence of magnetic resonance images (316) reconstructed using the first magnetic resonance imaging data (314).

9. The method of claim 8, the determining of the time of the maximum ventricular contraction during the second ventricular systole (434) comprising:
- identifying a ventricular state of maximum ventricular contraction during the second ventricular systole (434) using the sequence of magnetic resonance images (316);
- determining a time of the ventricular state of maximum ventricular contraction as the time of the maximum ventricular contraction.

10. The method of any of the previous claims, the time delay (324) further depending on a cardiac cycle length, the updating of the time delay (324) comprising:
- using a time interval between the first cardiac trigger (322; 412) and the second cardiac trigger, which are comprised by the received photoplethysmography data (320; 410), for determining a current cardiac cycle length;
- using the current cardiac cycle length for determining an updated cardiac cycle length;
- using the updated cardiac cycle length for determining the updated time delay (326).

11. The method of any of the previous claims, the method further comprising determining the time delay (324) using the cardiac cycle length, the determining of the time delay (324) comprising reducing the cardiac cycle length by a reduction time period sufficient long for ensuring the time-delayed first triggering using the time delay (324) resulting in the first magnetic resonance imaging data (314) acquisition being started before the start of the second ventricular systole (434),
more particularly the reduction time period comprises the trigger delay (332) and the predefined safety time period (336).

12. The method of any of the precious claims, the first magnetic resonance imaging data (314) acquisition comprising executing a SENC pulse sequence (312; 420) for the acquisition.

13. A computer program for synchronizing magnetic resonance imaging data acquisitions of a heart of a subject (118) with a cardiac cycle of the heart using photoplethysmography data (320; 410) of the subject (118),
the computer program comprising machine executable instructions (310) for execution by a computational system (300), wherein execution of the machine executable instructions (310) causes the computational system (300) to perform the method of any of the previous claims.

14. A medical system (150) comprising a computational system (300) for synchronizing magnetic resonance imaging data acquisitions of a heart of a subject (118) with a cardiac cycle of the heart using photoplethysmography data (320; 410) of the subject (118),
the computational system (300) comprising a memory (304) storing machine executable instructions (310), wherein execution of the machine executable instructions (310) causes the computational system (300) to perform the method of any of the previous claims 1 to 12.

15. The medical system (150) of claim 14, the medical system (150) further comprising one or more of the following:
an optical sensor (180) configured for acquiring the photoplethysmography data (320; 410), the machine executable instructions (310) further being configured for controlling the optical sensor (180) to acquire the photoplethysmography data (320; 410);
a magnetic resonance imaging system (152), the machine executable instructions (310) further being configured for controlling the medical imaging system (152) to execute the magnetic resonance imaging data acquisitions.
